# EUROPEAN PATENT APPLICATION

(11) **EP 4 546 417 A1**
(43) Date of publication of application: **30.04.2025**
(21) Application number: 24195523.6
(22) Date of filing: 21.08.2024
(51) Int. Cl.: H01L 23/528, H01L 21/285, H01L 23/535, H01L 21/768, H10D 84/01, H01L 21/74, H01L 23/48

(54) **SEMICONDUCTOR DEVICE**

(30) Priority: 27.10.2023 KR 20230145556; 02.04.2024 KR 20240044810
(71) Applicant: SAMSUNG ELECTRONICS CO., LTD., Yeongtong-gu Suwon-si, Gyeonggi-do 16677 (KR)
(72) Inventor: KIM, Ki Il, 16677 Suwon-si, Gyeonggi-do (KR); SUNG, Sug Hyun, 16677 Suwon-si, Gyeonggi-do (KR); UM, Myung Yoon, 16677 Suwon-si, Gyeonggi-do (KR); YOU, Jung Gun, 16677 Suwon-si, Gyeonggi-do (KR)
(74) Representative: Kuhnen & Wacker Patent- und Rechtsanwaltsbüro PartG mbB

(57) **Abstract**

A semiconductor device includes a back interlayer insulating film, a back wiring line disposed within the back interlayer insulating film, a fin-type pattern disposed on a first surface of the back wiring line, a source/drain pattern disposed on the fin-type pattern, and a back wiring contact connecting the back wiring line and source/drain pattern. A bottom surface of the source/drain pattern is connected to the fin-type pattern and faces the back wiring line. The back wiring contact includes a back contact barrier film, a back contact plug film, and a back ferroelectric material film. The back wiring contact includes a third surface facing the back wiring line. A vertical length from a second surface of the back wiring line to the third surface of the back wiring contact is less than a vertical length from the second surface to the bottom surface of the source/drain pattern.

## Description

### CROSS-REFERENCE TO RELATED APPLICATION

This application claims priority to Korean Patent Application No. 10-2024-0044810, filed on April 02, 2024, and Korean Patent Application No. 10-2023-0145556, filed on October 27, 2023, in the Korean Intellectual Property Office, the contents of which in their entirety are herein incorporated by reference.

### BACKGROUND

One of scaling schemes for increasing an integration density of a semiconductor device proposes a multi-gate transistor in which a multi-channel active pattern (or a silicon body) in a shape of a fin or a nanowire is formed on a substrate, and a gate is formed on a surface of the multi-channel active pattern.

Because such a multi-gate transistor uses a three-dimensional channel, it is easy to scale the same. Further, current control capability of the multi-gate transistor may be improved without increasing a gate length of the multi-gate transistor. In addition, the multi-gate transistor may effectively suppress SCE (short channel effect) in which potential of a channel area is affected by drain voltage.

As a pitch size of the semiconductor device decreases, research is needed to reduce capacitance between contacts in the semiconductor device and thus secure electrical stability of the device.

### SUMMARY

The present disclosure provides a semiconductor device having improved device performance and reliability.

According to an aspect of the present disclosure, there is provided a semiconductor device comprising a back interlayer insulating film, a back wiring line disposed within the back interlayer insulating film and including a first surface and a second surface opposite to each other in a first direction, a fin-type pattern disposed on the first surface of the back wiring line and extending in a second direction, a source/drain pattern disposed on the fin-type pattern, wherein a bottom surface of the source/drain pattern is connected to the fin-type pattern and faces the back wiring line, and a back wiring contact connecting the back wiring line and source/drain pattern to each other, wherein the back wiring contact includes a back contact barrier film, a back contact plug film, and a back ferroelectric material film disposed between the back contact barrier film and the back contact plug film, wherein the back wiring contact includes a third surface facing the back wiring line, wherein a vertical length from the second surface of the back wiring line to the third surface of the back wiring contact is smaller than a vertical length from the second surface of the back wiring line to the bottom surface of the source/drain pattern.

According to another aspect of the present disclosure, there is provided a semiconductor device comprising a back interlayer insulating film, a back wiring line disposed within the back interlayer insulating film and including a first surface and a second surface opposite to each other in a first direction, a first source/drain pattern disposed on the first surface of the back wiring line, and a back wiring contact disposed between the first source/drain pattern and the back wiring line, connected to the first source/drain pattern, and overlapping the first source/drain pattern in the first direction, wherein the back wiring contact includes a back contact barrier film, a back contact plug film, and a ferroelectric material film disposed between the back contact barrier film and the back contact plug film.

According to still another aspect of the present disclosure, there is provided a semiconductor device comprising a back interlayer insulating film, a back wiring line disposed within the back interlayer insulating film and including a first surface and a second surface opposite to each other in a first direction, a fin-type pattern disposed on the first surface of the back wiring line and extending in a second direction, a plurality of sheet patterns disposed on the fin-type pattern, a gate electrode disposed on the fin-type pattern, surrounding the plurality of sheet patterns, and extending in a third direction, a source/drain pattern disposed on the fin-type pattern and connected to the plurality of sheet patterns, wherein the source/drain pattern is disposed on a side surface of the gate electrode, wherein a bottom surface of the source/drain pattern is connected to the fin-type pattern, and faces the back wiring line, and a back wiring contact connecting the back wiring line and source/drain pattern to each other, wherein the back wiring contact includes a back contact barrier film, a back contact plug film, and a back ferroelectric material film disposed between the back contact barrier film and the back contact plug film, wherein the back wiring contact includes a third surface facing the back wiring line, wherein a vertical length from the second surface of the back wiring line to the third surface of the back wiring contact is smaller than a vertical length from the second surface of the back wiring line to the bottom surface of the source/drain pattern.

### BRIEF DESCRIPTION OF DRAWINGS

The above and other aspects and features of the present disclosure will become more apparent by describing in detail illustrative implementations thereof with reference to the attached drawings, in which:
FIG. 1 is an example layout diagram for illustrating a semiconductor device according to some implementations.
FIG. 2 is a cross-sectional view cut along A - A in FIG. 1.
FIG. 3 is a cross-sectional view cut along B - B in FIG. 1.
FIG. 4 is a cross-sectional view cut along C - C in FIG. 1.
FIG. 5 and FIG. 6 are diagrams for illustrating a semiconductor device according to some implementations.
FIG. 7 and FIG. 8 are diagrams for illustrating a semiconductor device according to some implementations.
FIG. 9 and FIG. 10 are diagrams for illustrating a semiconductor device according to some implementations.
FIGS. 11 to 13 are diagrams for illustrating semiconductor devices according to some implementations.
FIG. 14 and FIG. 15 are diagrams for illustrating a semiconductor device according to some implementations.
FIG. 16 is a diagram for illustrating a semiconductor device according to some implementations.
FIG. 17 is a diagram for illustrating a semiconductor device according to some implementations.
FIG. 18 is a diagram for illustrating a semiconductor device according to some implementations.
FIG. 19 and FIG. 20 are diagrams for illustrating a semiconductor device according to some implementations.
FIGS. 21 to 25 are diagrams for illustrating a semiconductor device according to some implementations.
FIGS. 26 to 30 are diagrams for illustrating a semiconductor device according to some implementations.
FIGS. 31 to 38 are diagrams of intermediate structures corresponding to intermediate steps of a semiconductor device manufacturing method according to some implementations.

### DETAILED DESCRIPTION

It will be understood that, although the terms "first", "second", "third", and so on may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described under could be termed a second element, component, region, layer or section, without departing from the spirit and scope of the present disclosure.

A semiconductor device according to some implementations includes a fin-type transistor (FinFET) including a channel area of a fin-type pattern shape, a transistor including nanowires or nanosheets, and a MBCFET^{™} (Multi-Bridge Channel Field Effect Transistor). However, the present disclosure is not limited thereto.

A semiconductor device according to some implementations may include a tunneling transistor (tunneling FET), a three-dimensional (3D) transistor, or a vertical transistor (Vertical FET). In another example, a semiconductor device according to some implementations may include a planar transistor. In addition, the technical concept of the present disclosure may be applied to a transistor (a 2D material-based FET) based on a two-dimensional material, and a heterostructure thereof.

Further, a semiconductor device according to some implementations may include a bipolar junction transistor, a LDMOS (Lateral Double Diffused MOS) transistor, or the like.

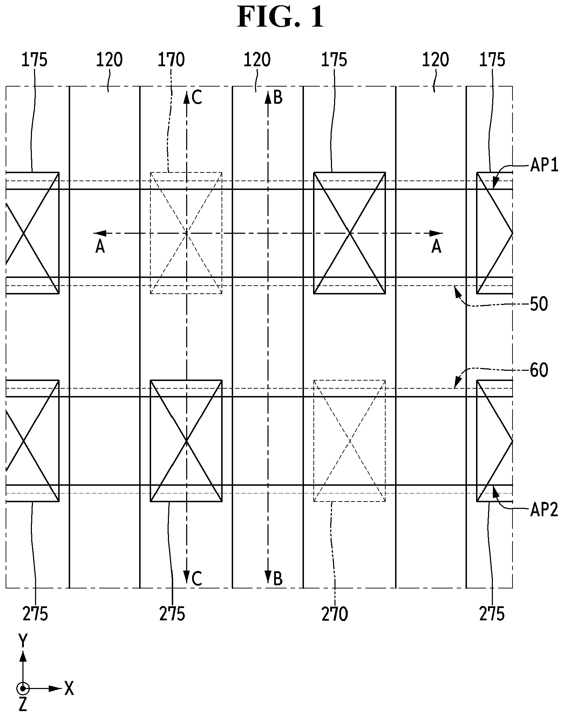

Referring to FIGS. 1 to 4, a semiconductor device according to some implementations is described.

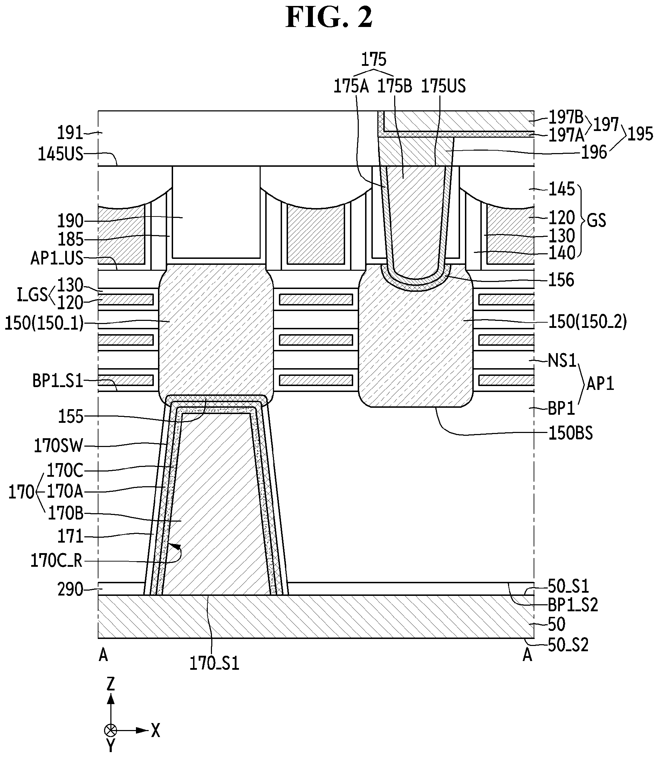

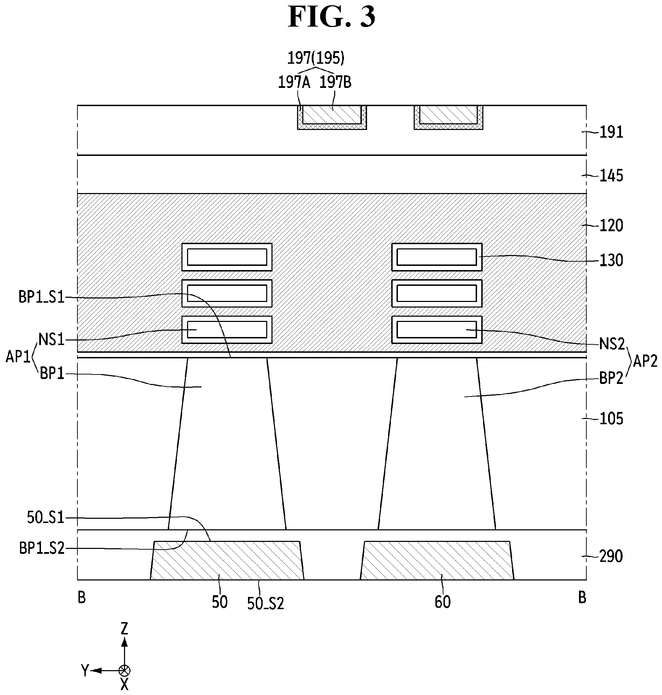

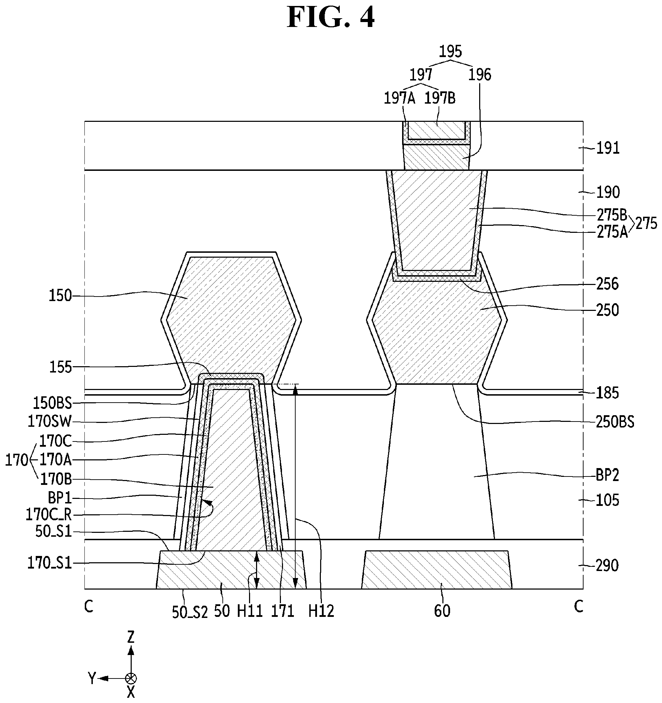

FIG. 1 is an example layout diagram for illustrating a semiconductor device according to some implementations. FIG. 2 is a cross-sectional view cut along A - A in FIG. 1. FIG. 3 is a cross-sectional view cut along B - B in FIG. 1. FIG. 4 is a cross-sectional view cut along C - C in FIG. 1.

A cross-sectional view of a second active pattern AP2 cut in a first direction X may be similar to FIG. 2.

Referring to FIGS. 1 to 4, a semiconductor device according to some implementations includes a first active pattern AP1, a second active pattern AP2, a plurality of gate electrodes 120, a first source/drain pattern 150, a second source/drain pattern 250, a first back wiring contact 170, a second back wiring contact 270, a first front source/drain contact 175, a second front source/drain contact 275, a first back wiring line 50, a second back wiring line 60, and a front wiring structure 195.

The first back wiring line 50 and the second back wiring line 60 may be disposed within a back interlayer insulating film 290. Each of the first back wiring line 50 and the second back wiring line 60 may extend in the first direction X. The first back wiring line 50 may be spaced apart from the second back wiring line 60 in a second direction Y

In one example, each of the first back wiring line 50 and the second back wiring line 60 may be a power line that supplies power to the semiconductor device. In another example, each of the first back wiring line 50 and the second back wiring line 60 may be a signal line that supplies an operation signal of the semiconductor device. In still another example, one of the first back wiring line 50 and the second back wiring line 60 may be a power line and the other thereof may be a signal line.

The first back wiring line 50 includes a first surface 50_S1 and a second surface 50_S2 that are opposite to each other in a third direction Z. The second back wiring line 60 may include a first surface and a second surface that are opposite to each other in the third direction Z. The first surface 50_S1 of the first back wiring line and the first surface of the second back wiring line 60 may face the first active pattern AP1 and the second active pattern AP2. In this regard, the first direction X may intersect with the second direction Y and the third direction Z. Furthermore, the second direction Y may intersect with the third direction Z.

Each of the first back wiring line 50 and the second back wiring line 60 are shown as having a trapezoidal cross-section. However, implementations of the present disclosure are not limited thereto. Unlike what is shown, each of the first back wiring line 50 and the second back wiring line 60 may have a rectangular cross-section. The first back wiring line 50 is described by way of example. A width in the second direction Y of the first surface 50_S1 of the first back wiring line may be smaller than a width in the second direction Y of the second surface 50_S2 of the first back wiring line.

For example, the first back wiring line 50 and the second back wiring line 60 may be formed using a damascene process. After forming a trench extending in the first direction X in the first back interlayer insulating film 290, the trench may be filled with a conductive material to form the first back wiring line 50.

Each of the first back wiring line 50 and the second back wiring line 60 is shown as having a single conductive film structure. However, implementations of the present disclosure are not limited thereto. Unlike what is shown, each of the first back wiring line 50 and the second back wiring line 60 may have a multi conductive film structure including a wiring barrier film and a wiring filling film, like the front wiring line 197 as shown in FIGS. 2 to 4.

Each of the first back wiring line 50 and the second back wiring line 60 may include at least one of, for example, metal, conductive metal nitride, conductive metal carbide, conductive metal oxide, conductive metal carbonitride, and two-dimensional material. The two-dimensional material (2D material) may include a two-dimensional allotrope or a two-dimensional compound. The two-dimensional material (2D material) may include, for example, at least one of graphene, boron nitride (BN), molybdenum sulfide, molybdenum selenide, tungsten sulfide, tungsten selenide, or tantalum sulfide. However, the present disclosure is not limited thereto. That is, the above-mentioned 2D materials are only listed by way of example. The 2D material that may be included in the semiconductor device according to some implementations of the present disclosure is not limited to the above-mentioned material.

Unlike what is shown, each of the first back wiring line 50 and the second back wiring line 60 may extend in the second direction Y In this case, a shape of a cross-sectional view thereof cut along each of A - A, B - B, and C - C in FIG. 1 may vary.

For example, the back interlayer insulating film 290 may include at least one of silicon oxide, silicon nitride, silicon carbonitride, silicon oxynitride, and a low dielectric (low-k) constant material. A dielectric constant of the low-k material may have a value lower than a dielectric constant of silicon oxide which is 3.9. The back interlayer insulating film 290 is shown as a single film. However, this is only for convenience of illustration, and implementations of the present disclosure are not limited thereto.

Each of the first active pattern AP1 and the second active pattern AP2 may be disposed on the back interlayer insulating film 290. A portion of the back interlayer insulating film 290 may be disposed between the first active pattern AP1 and the first back wiring line 50 and between the second active pattern AP2 and the second back wiring line 60.

Each of the first active pattern AP1 and the second active pattern AP2 may extend in an elongate manner in the first direction X. For example, the first active pattern AP1 and the second active pattern AP2 may be disposed on the first back wiring line 50 and the second back wiring line 60, respectively. The first active pattern AP1 and the second active pattern AP2 may be disposed on the first surface 50_S1 of the first back wiring line and the first surface of the second back wiring line 60, respectively.

The first active pattern AP1 and the second active pattern AP2 may be spaced apart from each other in the second direction Y The first active pattern AP1 and the second active pattern AP2 may be adjacent to each other in the second direction Y

The first active pattern AP1 is shown as being closest to the second active pattern AP2 in the second direction Y However, implementations of the present disclosure are not limited thereto. In another example, an additional active pattern may be disposed between the first active pattern AP1 and the second active pattern AP2.

In one example, the first active pattern AP1 may be an area where a p-type transistor is formed, and the second active pattern AP2 may be an area where an n-type transistor is formed. In another example, each of the first active pattern AP1 and the second active pattern AP2 may be an area where a p-type transistor is formed. In still another example, each of the first active pattern AP1 and the second active pattern AP2 may be an area where an n-type transistor is formed.

Each of the first active pattern AP1 and the second active pattern AP2 may be a multi-channel active pattern. For example, the first active pattern AP1 includes a first lower pattern BP1 and a plurality of first sheet patterns NS 1. The second active pattern AP2 includes a second lower pattern BP2 and a plurality of second sheet patterns NS2. In a semiconductor device according to some implementations, each of the first and second active patterns AP1 and AP2 may be an active pattern including a nanosheet or a nanowire.

The first lower pattern BP1 and the second lower pattern BP2 may be disposed on the back interlayer insulating film 290. In a semiconductor device according to some implementations, a portion of the back interlayer insulating film 290 may be disposed between the first lower pattern BP1 and the first back wiring line 50, and between the second lower pattern BP2 and the second back wiring line 60.

Each of the first lower pattern BP1 and the second lower pattern BP2 may protrude in the third direction Z. Each of the first lower pattern BP1 and the second lower pattern BP2 may be a fin-type pattern.

Each of the first lower pattern BP1 and the second lower pattern BP2 may extend in an elongate manner in the first direction X. The first lower pattern BP1 may be spaced apart from the second lower pattern BP2 in the second direction Y The first lower pattern BP1 and the second lower pattern BP2 may be isolated from each other via a fin trench extending in the first direction X.

The first lower pattern BP1 includes a first surface BP1_S1 and a second surface BP1_S2 that are opposite to each other in the third direction Z. The second surface BP1_S2 of the first lower pattern may face the back interlayer insulating film 290, the first back wiring line 50, and the second back wiring line 60. The first back wiring line 50 and the second back wiring line 60 may be disposed on the second surface BP1_S2 of the first lower pattern.

For example, the second surface BP1_S2 of the first lower pattern may be a bottom surface of the first lower pattern BP1. The first surface BP1_S1 of the first lower pattern may be an upper surface of the first lower pattern BP1.

The second lower pattern BP2 may include a first surface and a second surface that are opposite to each other in the third direction Z, as in the first lower pattern BP1. The second surface of the second lower pattern BP2 may face the back interlayer insulating film 290, the first back wiring line 50, and the second back wiring line 60.

In a semiconductor device according to some implementations, the first lower pattern BP1 may contact the back interlayer insulating film 290. The second lower pattern BP2 may contact the back interlayer insulating film 290.

The first lower pattern BP1 includes a sidewall connecting the first surface BP1_S1 of the first lower pattern and the second surface BP1_S2 of the first lower pattern to each other. The sidewall of the first lower pattern BP1 may extend in the first direction X. The second lower pattern BP2 may include a sidewall extending in the first direction X. The sidewall of the second lower pattern BP2 faces the sidewall of the first lower pattern BP1.

The plurality of first sheet patterns NS1 may be disposed on the first lower pattern BP1. The plurality of first sheet patterns NS1 may be disposed on the first surface BP1_S1 of the first lower pattern. The plurality of first sheet patterns NS1 may be spaced apart from the first lower pattern BP1 in the third direction Z.

The plurality of second sheet patterns NS2 may be disposed on the second lower pattern BP2. The plurality of second sheet patterns NS2 may be disposed on the first surface of the second lower pattern BP2. The plurality of second sheet patterns NS2 may be spaced apart from the second lower pattern BP2 in the third direction Z.

The first sheet pattern NS1 and the second sheet pattern NS2 may be disposed on the first surface 50_S1 of the first back wiring line and the first surface of the second back wiring line 60, respectively. It is shown that the three first sheet patterns NS1 and the three second sheet patterns NS2 are arranged in the third direction Z. However, this is only for convenience of illustration, and implementations of the present disclosure are not limited thereto.

The first sheet pattern NS1 may include an upper surface and a bottom surface that are opposite to each other in the third direction Z. The bottom surface of the first sheet pattern NS1 may face the first back wiring line 50.

The first sheet pattern NS1 may include the uppermost sheet pattern furthest from the first back wiring line 50 and the second back wiring line 60. The upper surface AP1_US of the first active pattern may be an upper surface of the uppermost sheet pattern among the first sheet pattern NS1. The description of the second active pattern AP2 and the second sheet pattern NS2 may be substantially the same as the description of the first active pattern AP1 and the first sheet pattern NS1.

Each of the first lower pattern BP1 and the second lower pattern BP2 may include silicon or germanium as an elemental semiconductor material. Alternatively, each of the first lower pattern BP1 and the second lower pattern BP2 may include a compound semiconductor, for example, a group IV-IV compound semiconductor or a group III-V compound semiconductor.

The group IV-IV compound semiconductor may include, for example, a binary compound including two of carbon (C), silicon (Si), germanium (Ge), and tin (Sn), a ternary compound including three thereof, or a compound obtained by doping a group IV element thereto.

The group III-V compound semiconductor may include, for example, a binary compound, a ternary compound, or a quaternary compound obtained by combining at least one of aluminum (Al), gallium (Ga), and indium (In) as a group III element and at least one of phosphorus (P), arsenic (As), and antimony (Sb) as a group V element with each other.

Each of the first and second sheet patterns NS 1 and NS2 may include one of the elemental semiconductor material such as silicon or germanium, the group IV-IV compound semiconductor and the group III-V compound semiconductor. A width in the second direction Y of the first sheet pattern NS1 may increase or decrease in proportion to a width in the second direction Y of the first lower pattern BP1. A width in the second direction Y of the second sheet pattern NS2 may increase or decrease in proportion to a width in the second direction Y of the second lower pattern BP2.

Taking the first sheet patterns NS1 by way of example, although it is illustrated that the widths in the second direction Y of the first sheet patterns NS 1 disposed on the first lower pattern BP1 are equal to each other, implementations of the present disclosure are not limited thereto.

The field insulating film 105 may be disposed on the first back wiring line 50 and the second back wiring line 60. For example, the field insulating film 105 may be disposed on the first surface 50_S1 of the first back wiring line and the first surface of the second back wiring line 60.

The field insulating film 105 may be disposed on the sidewall of the first lower pattern BP1 and the sidewall of the second lower pattern BP2. In one example, the field insulating film 105 may cover an entirety of the sidewall of the first lower pattern BP1 and an entirety of the sidewall of the second lower pattern BP2. Unlike what is shown, in another example, the field insulating film 105 may cover a portion of the sidewall of the first lower pattern BP1 and/or a portion of the sidewall of the second lower pattern BP2.

The field insulating film 105 does not cover the first surface of the first lower pattern BP1_S1 and the first surface of the second lower pattern BP2. Based on the first back wiring line 50 and the second back wiring line 60, the first sheet pattern NS1 and the second sheet pattern NS2 are disposed above an upper surface of the field insulating film 105. The field insulating film 105 may include upper and bottom surfaces opposite to each other in the third direction Z. The bottom surface of the field insulating film 105 faces the first back wiring line 50 and the second back wiring line 60.

The field insulating film 105 may include, for example, an oxide film, a nitride film, an oxynitride film, or a combination thereof. The field insulating film 105 is shown as a single film. However, this is only for convenience of illustration, and implementations of the present disclosure are not limited thereto.

A plurality of gate structures GS may be disposed on the upper surface of the field insulating film 105. Each gate structure GS may extend in the second direction Y The gate structures GS may be arranged to be spaced apart from each other in the first direction X. The gate structures GS may be adjacent to each other in the first direction X.

The gate structure GS may be disposed on the first active pattern AP1 and the second active pattern AP2. The gate structure GS may intersect the first active pattern AP1 and the second active pattern AP2.

The gate structure GS may be disposed on the first lower pattern BP1 and the second lower pattern BP2. The gate structure GS may surround each of the first sheet patterns NS1. The gate structure GS may surround each of the second sheet patterns NS2.

The gate structure GS is shown as extending across the first active pattern AP1 and the second active pattern AP2. However, this is only for convenience of illustration, and implementations of the present disclosure are not limited thereto. That is, the gate structure GS may be divided into two portions via a gate isolation structure disposed on the field insulating film 105, such that the two portions are disposed on the first active pattern AP1 and the second active pattern AP2, respectively.

The gate structure GS may include, for example, a gate electrode 120, a gate insulating film 130, a gate spacer 140, and a gate capping pattern 145.

The gate structure GS includes a plurality of inner gate structure I_GS disposed respectively between the first sheet patterns NS1 adjacent to each other in the third direction Z and between the first lower pattern BP1 and the bottommost first sheet pattern NS1. Each inner gate structure I_GS may be disposed respectively between the first surface BP1_S1 of the first lower pattern and the bottom surface of the first sheet pattern NS1, and between the upper surface of the first sheet pattern NS 1 and the bottom surface of the first sheet pattern NS 1 adj acent thereto facing each other in the third direction Z. Each inner gate structure I_GS includes the gate electrode 120 and the gate insulating film 130.

The number of inner gate structures I_GS may be equal to the number of the first sheet patterns NS1. Each inner gate structure I_GS contacts the first surface BP1_S1 of the first lower pattern, the upper surface of the first sheet pattern NS1, and the bottom surface of the first sheet pattern NS1. In a semiconductor device according to some implementations, the inner gate structure I_GS may contact the first source/drain pattern 150, which will be described later.

Each inner gate structure I_GS includes the gate electrode 120 and the gate insulating film 130 disposed between adjacent first sheet patterns NS1, or between the first lower pattern BP1 and the first sheet pattern NS 1.

The inner gate structures I_GS may be respectively disposed between the second sheet patterns NS2 adjacent to each other in the third direction Z, and between the second lower pattern BP2 and the bottommost second sheet pattern NS2.

The gate electrode 120 may be disposed on the first lower pattern BP1 and the second lower pattern BP2. The gate electrode 120 may intersect the first lower pattern BP1 and the second lower pattern BP2. The gate electrode 120 may surround each of the first sheet patterns NS1 and the second sheet patterns NS2.

In the cross-sectional view as shown in FIG. 2, an upper surface of the gate electrode 120 is illustrated to be a concavely curved surface. However, the present disclosure is not limited thereto. In another example, the upper surface of the gate electrode 120 may be flat.

The gate electrode 120 may include at least one of metal, conductive metal nitride, metal silicide, doped semiconductor material, conductive metal oxide, conductive metal silicon nitride, and conductive metal oxynitride. The gate electrode 120 may include, for example, at least one of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAlN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V) or combinations thereof. The present disclosure is not limited thereto. The conductive metal oxide and the conductive metal oxynitride may include oxidized products of the above-mentioned materials. The present disclosure is not limited thereto.

The gate insulating film 130 may extend along the upper surface of the field insulating film 105, the first surface BP1_S1 of the first lower pattern, and the first surface of the second lower pattern BP2. The gate insulating film 130 may surround each of the plurality of first sheet pattern NS1. The gate insulating film 130 may surround each of the plurality of second sheet patterns NS2. The gate insulating film 130 may be disposed around each of the first sheet pattern NS1 and the second sheet pattern NS2. The gate electrode 120 is disposed on the gate insulating film 130.

The gate insulating film 130 is disposed between the gate electrode 120 and each first sheet pattern NS1 and between the gate electrode 120 and each second sheet pattern NS2. In a semiconductor device according to some implementations, the gate insulating film 130 included in the inner gate structure I_GS may contact the first source/drain pattern 150 to be described later.

The gate insulating film 130 may include silicon oxide, silicon oxynitride, silicon nitride, or a high dielectric constant material having a higher dielectric constant than that of silicon oxide. The high dielectric constant (high-k) material may include, for example, at least one of boron nitride, hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, or lead zinc niobate.

Although the gate insulating film 130 is illustrated as being embodied as a single film, this is intended only for convenience of illustration, and the present disclosure is not limited thereto. The gate insulating film 130 may include a plurality of films. The gate insulating film 130 may include an interfacial film and a high dielectric constant insulating film disposed between the first active pattern AP1 and the gate electrode 120 and between the second active pattern AP2 and the gate electrode 120. For example, the interfacial film may not be formed along a profile of the upper surface of the field insulating film 105.

The semiconductor device according to some implementations may include an NC (negative capacitance) FET using a negative capacitor. For example, the gate insulating film 130 may include a gate ferroelectric material film having ferroelectric properties and a gate paraelectric material film having paraelectric properties.

The gate ferroelectric material film may have negative capacitance, and the gate paraelectric material film may have positive capacitance. For example, when two or more capacitors may be connected in series to each other, and capacitance of each of the capacitors has a positive value, a total capacitance is smaller than capacitance of each individual capacitor. On the contrary, when at least one of capacitances of two or more capacitors connected in series to each other has a negative value, a total capacitance may have a positive value and be greater than an absolute value of each individual capacitance.

When the gate ferroelectric material film with negative capacitance and the gate paraelectric material film with positive capacitance are connected in series to each other, a total capacitance value of the gate ferroelectric material film and the gate paraelectric material film connected in series to each other may be increased. Using the increase in the total capacitance value, a transistor including the gate ferroelectric material film may have a subthreshold swing (SS) lower than about 60 mV/decade at room temperature.

The gate ferroelectric material film may have ferroelectric properties. The gate ferroelectric material film may include, for example, at least one of hafnium oxide, hafnium zirconium oxide, barium strontium titanium oxide, barium titanium oxide, and lead zirconium titanium oxide. In this connection, in one example, hafnium zirconium oxide may refer to a material obtain by doping hafnium oxide with zirconium (Zr). In another example, hafnium zirconium oxide may refer to a compound of hafnium (Hf), zirconium (Zr), and oxygen (O).

The gate ferroelectric material film may further contain doped dopants. For example, the dopant may include at least one of aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr) and tin (Sn). A type of the dopant contained in the gate ferroelectric material film may vary depending on a type of the ferroelectric material included in the gate ferroelectric material film.

When the gate ferroelectric material film includes hafnium oxide, the dopant contained in the gate ferroelectric material film may include, for example, at least one of gadolinium (Gd), silicon (Si), zirconium (Zr), aluminum (Al), and yttrium (Y).

When the dopant is aluminum (Al), the gate ferroelectric material film may contain about 3 to about 8 at% (atomic %) of aluminum. In this connection, a content of the dopant may be a content of aluminum based on a sum of hafnium and aluminum.

When the dopant is silicon (Si), the gate ferroelectric material film may contain about 2 to about 10 at% of silicon. When the dopant is yttrium (Y), the gate ferroelectric material film may contain about 2 to about 10 at% yttrium. When the dopant is gadolinium (Gd), the gate ferroelectric material film may contain about 1 to about 7 at% gadolinium. When the dopant is zirconium (Zr), the gate ferroelectric material film may contain about 50 to about 80 at% zirconium.

The gate paraelectric material film may have paraelectric properties. The gate paraelectric material film may include, for example, at least one of silicon oxide and metal oxide having a high dielectric constant. Although the metal oxide contained in the gate paraelectric material film may include, for example, at least one of hafnium oxide, zirconium oxide and aluminum oxide. However, the present disclosure is not limited thereto.

The gate ferroelectric material film and the gate paraelectric material film may include the same material. The gate ferroelectric material film may have ferroelectric properties, but the gate paraelectric material film may not have the ferroelectric properties. For example, when each of the gate ferroelectric material film and the gate paraelectric material film includes hafnium oxide or hafnium zirconium oxide, a crystal structure of hafnium oxide contained in the gate ferroelectric material film is different from a crystal structure of hafnium oxide contained in the gate paraelectric material film. For example, the gate ferroelectric material film may include a crystal grain having an orthorhombic crystal system.

The gate ferroelectric material film may have a thickness sized to exhibit ferroelectric properties. Although the thickness of the gate ferroelectric material film may be, for example, in a range of about 0.5 to about 10nm, the present disclosure is not limited thereto. Because a critical thickness exhibiting the ferroelectric properties may be vary based on a type of the ferroelectric material, the thickness of the gate ferroelectric material film may vary depending on the type of the ferroelectric material.

In one example, the gate insulating film 130 may include one gate ferroelectric material film. In another example, the gate insulating film 130 may include a plurality of gate ferroelectric material films spaced apart from each other. The gate insulating film 130 may have a multilayer structure in which a plurality of gate ferroelectric material films and a plurality of gate paraelectric material films are alternately stacked on top of each other.

The gate spacer 140 may be disposed on a sidewall of the gate electrode 120. The gate spacer 140 may not be disposed between the first lower pattern BP1 and the lowest first sheet pattern NS1 and between the first sheet patterns NS1 adjacent to each other in the third direction D3.

The gate spacer 140 may include, for example, at least one of silicon nitride (SiN), silicon oxynitride (SiON), silicon oxide (SiO₂), silicon oxycarbonitride (SiOCN), silicon boron nitride (SiBN), silicon oxyboron nitride (SiOBN), silicon oxycarbide (SiOC), or combinations thereof. The present disclosure is not limited thereto. Although it is illustrated that the gate spacer 140 is embodied as a single film, this is intended only for convenience of illustration and the present disclosure is not limited thereto.

The gate capping pattern 145 may be disposed on the gate electrode 120. An upper surface 145US of the gate capping pattern may be coplanar with the upper surface of the first front interlayer insulating film 190.

Unlike what is shown, in one example, the gate capping pattern 145 may be disposed between the gate spacers 140. In another example, the gate structure GS may not include the gate capping pattern 145. The gate capping pattern may not be disposed on the gate electrode 120.

For example, the gate capping pattern 145 may include at least one of silicon nitride (SiN), silicon oxynitride (SiON), silicon carbonitride (SiCN), silicon oxycarbonitride (SiOCN), and combinations thereof. The gate capping pattern 145 may include a material having an etch selectivity with respect to a material of the first front interlayer insulating film 190.

The first source/drain pattern 150 may be disposed on the first active pattern AP1. The first source/drain pattern 150 may be disposed on the first lower pattern BP1. The first source/drain patterns 150 disposed on the first active pattern AP1 may be spaced apart from each other in the first direction X.

The first source/drain pattern 150 may be disposed between the gate electrodes 120 adjacent to each other in the first direction X. The first source/drain pattern 150 may be disposed on a side surface of the gate electrode 120. The first source/drain pattern 150 may contact the first active pattern AP1. The first source/drain pattern 150 may contact the first sheet pattern NS 1. The first source/drain pattern 150 may be disposed on the first surface 50_S1 of the first back wiring line and the first surface of the second back wiring line 60.

The first source/drain pattern 150 includes a first back connection epitaxial pattern 150_1 and a first front connection epitaxial pattern 150_2. The first back connection epitaxial pattern 150_1 may be connected to the first back wiring line 50. The first front connection epitaxial pattern 150_2 may be connected to the front wiring line 197.

The second source/drain pattern 250 may be disposed on the second active pattern AP2. The second source/drain pattern 250 may be disposed on the second lower pattern BP2. The second source/drain pattern 250 may be spaced apart from the first source/drain pattern 150 in the second direction Y

The second source/drain pattern 250 may contact the second active pattern AP2. The second source/drain pattern 250 may contact the second sheet pattern NS2. The second source/drain pattern 250 may be disposed on the first surface 50_S1 of the first back wiring line and the first surface of the second back wiring line 60.

Like the first source/drain pattern 150, the second source/drain pattern 250 may include a back connection epitaxial pattern connected to the second back wiring line 60, and a front connection epitaxial pattern connected to the front wiring line 197.

The first source/drain pattern 150 may be included in a source/drain of a transistor that uses the first sheet pattern NS1 as a channel area. The second source/drain pattern 250 may be included in a source/drain of a transistor using the second sheet pattern NS2 as a channel area.

In FIG. 4, a shape of each of the first source/drain pattern 150 and the second source/drain pattern 250 is shown to be similar to a hexagon. However, implementations of the present disclosure are not limited thereto. Unlike what is shown, the shape of each of the first source/drain pattern 150 and the second source/drain pattern 250 may be similar to a pentagon or quadrangle.

The first source/drain pattern 150 includes a bottom surface 150BP facing the first lower pattern BP1. A bottom surface 150BS of the first source/drain pattern may be connected to the first lower pattern BP1. The bottom surface 150BS of the first source/drain pattern may be disposed under the first surface BP1_S1 of the first lower pattern. For example, the bottom surface 150BS of the first source/drain pattern may contact the first lower pattern BP1. The second source/drain pattern 250 includes a bottom surface 250BS connected to the second lower pattern BP2.

Each of the first source/drain pattern 150 and the second source/drain pattern 250 may include an epitaxial pattern. Each of the first source/drain pattern 150 and the second source/drain pattern 250 may include a semiconductor material.

Each of the first source/drain pattern 150 and the second source/drain pattern 250 may include, for example, silicon or germanium as an elemental semiconductor material. Alternatively, each of the first source/drain pattern 150 and the second source/drain pattern 250 may include, for example, a binary compound including two of carbon (C), silicon (Si), germanium (Ge), and tin (Sn), a ternary compound including three thereof, or a compound obtained by doping a group IV element thereto. Each of the first source/drain pattern 150 and the second source/drain pattern 250 may include an epitaxial film made of a semiconductor material. Each of the first source/drain pattern 150 and the second source/drain pattern 250 is shown as a single film. However, this is only for convenience of illustration, and implementations of the present disclosure are not limited thereto.

Each of the first source/drain pattern 150 and the second source/drain pattern 250 may contain a dopant doped into a semiconductor material. In one example, each of the first source/drain pattern 150 and the second source/drain pattern 250 may contain a p-type dopant. In another example, each of the first source/drain pattern 150 and the second source/drain pattern 250 may contain an n-type dopant. In still another example, the first source/drain pattern 150 may contain a p-type dopant, and the second source/drain pattern 250 may contain an n-type dopant.

For example, the p-type dopant may include at least one of boron (B) and gallium (Ga). However, implementations of the present disclosure are not limited thereto. For example, the n-type dopant may include at least one of phosphorus (P), arsenic (As), antimony (Sb), and bismuth (Bi). However, implementations of the present disclosure are not limited thereto.

The first front interlayer insulating film 190 is disposed on the first lower pattern BP1, the second lower pattern BP2, and the field insulating film 105. The first front interlayer insulating film 190 may be disposed on the first source/drain pattern 150 and the second source/drain pattern 250. The first front interlayer insulating film 190 may not cover the upper surface 145US of the gate capping pattern. For example, the upper surface of the first front interlayer insulating film 190 may be coplanar with the upper surface 145US of the gate capping pattern.

The first front interlayer insulating film 190 is disposed on the first surface 50_S1 of the first back wiring line and the first surface of the second back wiring line 60.

For example, the first front interlayer insulating film 190 may include at least one of silicon oxide, silicon nitride, silicon oxynitride, and a low dielectric constant material. The low dielectric constant material may include, for example, fluorinated tetraethylorthosilicate (FTEOS), hydrogen silsesquioxane (HSQ), bis-benzocyclobutene (BCB), tetramethylorthosilicate (TMOS), octamethyleyclotetrasiloxane (OMCTS), hexamethyldisiloxane (HMDS), trimethylsilyl borate (TMSB), diacetoxyditertiarybutosiloxane (DADBS), trimethylsilil phosphate (TMSP), polytetrafluoroethylene (PTFE), TOSZ (Tonen SilaZen), FSG (fluoride silicate glass), polyimide nanofoams such as polypropylene oxide, CDO (carbon doped silicon oxide), OSG (organo silicate glass), SiLK, amorphous fluorinated carbon, silica aerogels, silica xerogels, mesoporous silica, or combinations thereof. However, the spirit of the present disclosure is not limited thereto.

A source/drain etch stop film 185 may extend along a profile of the first source/drain pattern 150 and a profile of the second source/drain pattern 250. The source/drain etch stop film 185 may be disposed between the first source/drain pattern 150 and the first front interlayer insulating film 190, and between the second source/drain pattern 250 and the first front interlayer insulating film 190.

The source/drain etch stop film 185 may include, for example, at least one of silicon nitride (SiN), silicon oxynitride (SiON), silicon oxycarbonitride (SiOCN), silicon boron nitride (SiBN), silicon oxyboron nitride (SiOBN), silicon oxycarbide (SiOC), or combinations thereof.

The first back wiring contact 170 may extend in an elongate manner in the third direction Z. The first back wiring contact 170 may be connected to the first source/drain pattern 150. For example, the first back wiring contact 170 may be connected to the first back connection epitaxial pattern 150_1. The first back wiring contact 170 is electrically connected to the first source/drain pattern 150.

The first back wiring contact 170 may connect the first source/drain pattern 150 and the first back wiring line 50 to each other. The first back wiring contact 170 may be connected to the first back wiring line 50. The first back wiring contact 170 may be connected to the first surface 50_S1 of the first back wiring line.

The first back wiring contact 170 may be disposed between the first source/drain pattern 150 and the first back wiring line 50. In a semiconductor device according to some implementations, the first back wiring contact 170 may overlap the first back wiring line 50 and the first source/drain pattern 150 in the third direction Z. The first back wiring contact 170 may overlap the bottom surface 150BS of the first source/drain pattern in the third direction Z.

For example, at least a portion of the first back wiring contact 170 may be disposed within the back interlayer insulating film 290 and the first lower pattern BP1. A portion of the first back wiring contact 170 may be disposed within the back interlayer insulating film 290. The first back wiring contact 170 may extend from the first surface 50_S1 of the first back wiring line to the first source/drain pattern 150. Unlike what is shown, the back interlayer insulating film 290 may not be disposed between the second surface BP1_S2 of the first lower pattern and the first surface 50_S1 of the first back wiring line.

The first back wiring contact 170 includes a first surface 170_S1 facing the first back wiring line 50. The first surface 170_S1 of the first back wiring contact may be connected to the first back wiring line 50. The first back wiring contact 170 includes a sidewall 170SW extending in the third direction Z from the first surface 170_S1 of the first back wiring contact.

The first back wiring contact 170 includes a first back contact barrier film 170A, a first back contact plug film 170B, and a first back ferroelectric material film 170C. The first back ferroelectric material film 170C may be disposed between the first back contact barrier film 170A and the first back contact plug film 170B.

The first back ferroelectric material film 170C may extend along a profile of the first back contact barrier film 170A. The first back ferroelectric material film 170C may define a first contact plug recess 170C_R. The first back contact plug film 170B may fill the first contact plug recess 170C_R. The first back ferroelectric material film 170C may extend along a sidewall of the first back contact plug film 170B extending in the third direction Z. The first back ferroelectric material film 170C may extend along a bottom surface of the first back contact plug film 170B. The bottom surface of the first back contact plug film 170B faces the first source/drain pattern 150.

A vertical length H11 from the second surface 50_S2 of the first back wiring line to the first surface 170_S1 of the first back wiring contact may be smaller than a vertical length H12 from the second surface 50_S2 of the first back wiring line to the bottom surface 150BS of the first source/drain pattern. The vertical length H12 from the second surface 50_S2 of the first back wiring line to the bottom surface 150BS of the first source/drain pattern may be measured in a cross-sectional view such as FIG. 2 rather than a cross-sectional view such as FIG. 4.

As a scaling of the semiconductor device decreases, a size of the back wiring contact connected to the back wiring line is decreasing. As the size of the back wiring contact decreases, a resistance of the back wiring contact may increase.

The first back ferroelectric material film 170C may be disposed between the first back contact barrier film 170A and the first back contact plug film 170B, such that the resistance of the first back wiring contact 170 may be reduced. Thus, current flow in the third direction Z in the first back wiring contact 170 may be improved. Thus, the performance and reliability of the semiconductor device may be improved.

The first back contact barrier film 170A may include, for example, at least one of metal, conductive metal nitride, conductive metal carbide, conductive metal oxide, conductive metal oxynitride, conductive metal silicon nitride, conductive metal carbonitride, and two-dimensional material. The first back contact plug film 170B may include metal. The first back ferroelectric material film 170C may include a ferroelectric material. Description about the first back ferroelectric material film 170C may be substantially the same as the description about the gate ferroelectric material film as described above.

A first back contact silicide film 155 may be disposed between the first back wiring contact 170 and the first source/drain pattern 150. The first back contact silicide film 155 contacts the first back wiring contact 170. The first back contact silicide film 155 may include a metal silicide material.

A contact insulating liner 171 may extend along the sidewall 170SW of the first back wiring contact. The contact insulating liner 171 may be disposed between the first back wiring contact 170 and the first lower pattern BP1. Unlike what is shown, the contact insulating liner 171 may not be disposed between the first back wiring contact 170 and the first lower pattern BP1. The contact insulating liner 171 may include an insulating material.

A connection structure in which the second back wiring contact 270 is electrically connected to the second source/drain pattern 250 on the second lower pattern BP2 may be similar to that as shown in FIG. 2 and FIG. 4. The second back wiring contact 270 may be connected to the second back wiring line 60.

The first front source/drain contact 175 may extend in the third direction Z. The first front source/drain contact 175 may be connected to the first source/drain pattern 150. For example, the first front source/drain contact 175 may be connected to the first front source/drain pattern 150_2. The first front source/drain contact 175 is electrically connected to the first source/drain pattern 150.

The first front source/drain contact 175 is disposed on the first surface BP1_S1 of the first lower pattern. The first source/drain pattern 150 may be disposed between the first front source/drain pattern 175 and the first back wiring line 50. The first front source/drain contact 175 may be disposed within the first front interlayer insulating film 190 and the first source/drain pattern 150. A portion of the first front source/drain contact 175 may be disposed within the first source/drain pattern 150. The first front source/drain contact 175 does not extend through the first lower pattern BP1.

A vertical length from the upper surface of the first active pattern AP1_US to the upper surface 175US of the first front source/drain contact may be equal to a vertical length from the upper surface of the first active pattern AP1_US to the upper surface 145US of the first gate capping pattern.

The second front source/drain contact 275 may be disposed on the second source/drain pattern 250. The second source/drain pattern 250 may be disposed between the second front source/drain pattern 275 and the second back wiring line 60. The second front source/drain contact 275 is disposed on the first surface 50_S1 of the first back wiring line. The second front source/drain contact 275 may be connected to the second source/drain pattern 250. The second front source/drain contact 275 is electrically connected to the second source/drain pattern 250.

The first front source/drain contact 175 includes the first front contact barrier film 175A and the first front contact plug film 175B. The second front source/drain contact 275 includes a second front contact barrier film 275A and a second front contact plug film 275B.

Each of the first front contact barrier film 175A and the second front contact barrier film 275A may include at least one of, for example, metal, conductive metal nitride, conductive metal carbide, conductive metal oxide, conductive metal oxynitride, conductive metal silicon nitride, conductive metal carbonitride and two-dimensional material. Each of the first front contact plug film 175B and the second front contact plug film 275B may include metal.

The first front contact silicide film 156 may be disposed between the first front source/drain contact 175 and the first source/drain pattern 150. The second front contact silicide film 256 may be disposed between the second front source/drain contact 275 and the second source/drain pattern 250. Each of the first front contact silicide film 156 and the second front contact silicide film 256 may include a metal silicide material.

The second front interlayer insulating film 191 may be disposed on the first front interlayer insulating film 190, the gate structure GS, and the front source/drain contacts 175 and 275. The second front interlayer insulating film 191 may include, for example, at least one of silicon oxide, silicon nitride, silicon carbonitride, silicon oxynitride, and a low dielectric constant material.

The front wiring structure 195 may be disposed within the second front interlayer insulating film 191. The front wiring structure 195 is disposed on the first surface 50_S1 of the first back wiring line and the first surface of the second back wiring line 60. The front wiring structure 195 includes a front via plug 196 and a front wiring line 197.

The front wiring structure 195 may be connected to the first front source/drain contact 175. The front wiring structure 195 may be connected to the upper surface 175US of the first front source/drain contact.

The first front source/drain contact 175 may be disposed between the front wiring structure 195 and the first source/drain pattern 150. The first front source/drain contact 175 may connect the front wiring structure 195 and the first source/drain pattern 150 to each other. The first front source/drain contact 175 may be connected to the front wiring line 197. For example, the front wiring structure 195 may not be connected to the first source/drain pattern 150 which is connected to the first back wiring contact 170.

Unlike what is shown, the front wiring structure 195 may be connected to the first back connection epitaxial pattern 150_1 via another front source/drain contact. That is, the front wiring structure 195 may be connected to the first back wiring contact 170 via the first back connection epitaxial pattern 150_1.

The front wiring structure 195 may be connected to the second front source/drain contact 275. The descriptions about the first front source/drain contact 175 may be applied to the second front source/drain contact 275.

The front wiring structure 195 may include the front via plug 196 and the front wiring line 197. The front wiring line 197 includes a front wiring barrier film 197A and a front wiring plug film 197B.

The front via plug 196 may have a single conductive film structure. The front wiring line 197 may have a multi-conductive film structure.

Unlike what is shown, in one example, the front via plug 196 may have a multi-conductive film structure like the front wiring line 197. In another example, the front wiring line 197 may have a single conductive film structure like the front via plug 196. In still another example, the front via plug 196 and the front wiring line 197 may have an integrated structure with each other while a boundary is absent therebetween.

The front wiring barrier film 197A may include at least one of metal, conductive metal nitride, conductive metal carbide, conductive metal oxide, conductive metal oxynitride, conductive metal silicon nitride, conductive metal carbonitride, and two-dimensional material. Each of the front via plug 196 and the front wiring plug film 197B may include metal.

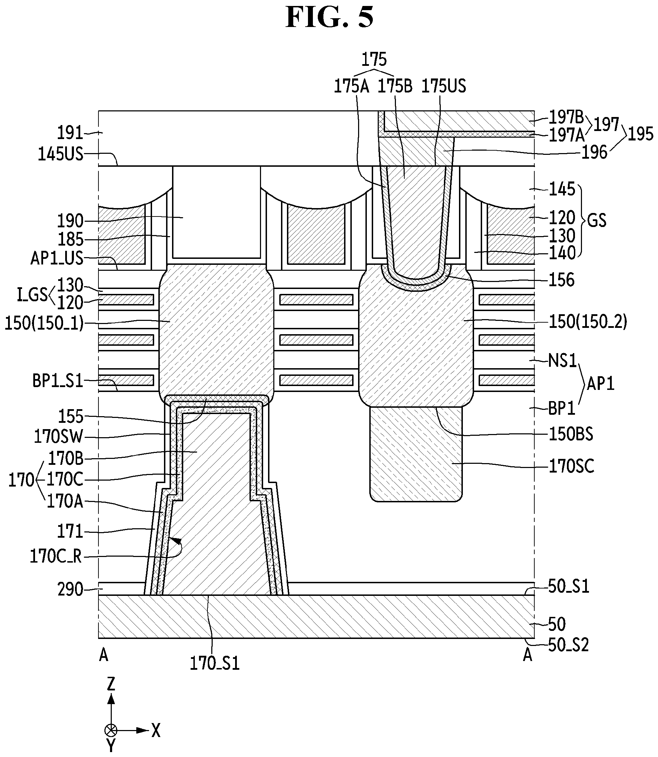

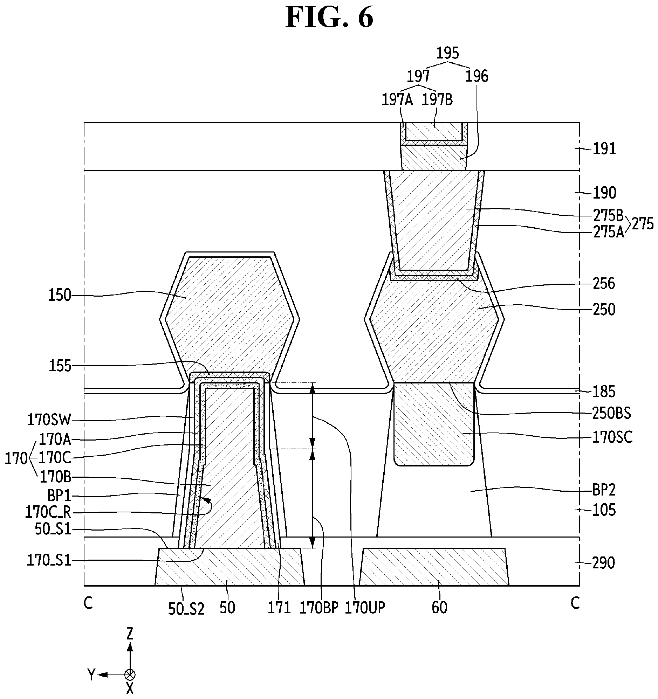

FIG. 5 and FIG. 6 are diagrams for illustrating a semiconductor device according to some implementations. For convenience of description, the following description focuses on differences thereof from the description set forth above using FIG. 1 to FIG. 4.

Referring to FIG. 5 and FIG. 6, the semiconductor device according to some implementations may further include a sacrificial epitaxial pattern 170SC disposed within the first lower pattern BP1.

The sacrificial epitaxial pattern 170SC may be disposed between the first source/drain pattern 150 and the first back wiring line 50. The first source/drain pattern 150 may be disposed on the sacrificial epitaxial pattern 170SC.

The sacrificial epitaxial pattern 170SC may overlap the first source/drain pattern 150 in the third direction Z. The sacrificial epitaxial pattern 170SC may overlap with the first back wiring contact 170 in the first direction X.

For example, the sacrificial epitaxial pattern 170SC may be disposed between the first front connection epitaxial pattern 150_2 and the first back wiring line 50. The first front connection epitaxial pattern 150_2 may be disposed on the sacrificial epitaxial pattern 170SC. The first front connection epitaxial pattern 150_2 may overlap with the sacrificial epitaxial pattern 170SC in the third direction Z.

The sacrificial epitaxial pattern 170SC may be disposed within the second lower pattern BP2. The sacrificial epitaxial pattern 170SC may be disposed under the second source/drain pattern 250 connected to the front wiring line 197. The sacrificial epitaxial pattern 170SC may be disposed between the second source/drain pattern 250 and the second back wiring line 60.

The sacrificial epitaxial pattern 170SC may include a material having an etch selectivity relative to a material of each of the first and second lower patterns BP1 and BP2. The sacrificial epitaxial pattern 170SC may include a semiconductor material.

The first back wiring contact 170 includes a first portion 170BP and a second portion 170UP. The first portion 170BP of the first back wiring contact is directly connected to the second portion 170UP of the first back wiring contact. The first portion 170BP of the first back wiring contact may be disposed between the second portion 170UP of the first back wiring contact and the first back wiring line 50. For example, the second portion 170UP of the first back wiring contact may be formed by filling a space obtained by removing the sacrificial epitaxial pattern 170SC with a conductive material and a ferroelectric material.

A width in the second direction Y of the first portion 170BP of the first back wiring contact 170 decreases as the first portion extends away from the first surface 50_S1 of the first back wiring line. A width in the second direction Y of the second portion 170UP of the first back wiring contact 170UP is shown to be constant. However, this is only for convenience of illustration, and implementations of the present disclosure are not limited thereto.

In one example, at a point where a width in the first direction X or the second direction Y of the first back wiring contact 170 changes, the second portion 170UP of the first back wiring contact may be distinguished from the first portion 170BP of the first back wiring contact. For example, near a boundary between the second portion 170UP of the first back wiring contact and the first portion 170BP of the first back wiring contact, the width of the first back wiring contact 170 may suddenly decrease.

In another example, at the point where a slope of the sidewall 170SW of the first back wiring contact changes, the second portion 170UP of the first back wiring contact may be distinguished from the first portion 170BP of the first back wiring contact. Near the boundary between the second portion 170UP of the first back wiring contact and the first portion 170BP of the first back wiring contact, the slope of the sidewall 170SW of the first portion 170BP of the first back wiring contact may be different from the slope of the sidewall 170SW of the second portion 170UP of the first back wiring contact.

Based on the change tendency in the width of the first back wiring contact 170 or the change in the slope of the sidewall 170SW of the first back wiring contact, the second portion 170UP of the first back wiring contact may be distinguished from the first portion 170BP thereof.

Unlike what is shown, the width in the first direction X or the second direction Y of the first back wiring contact 170 continuously decreases as the first back wiring contact 170 extends away from the first surface 50_S 1 of the first back wiring line. Alternatively, the first back wiring contact 170 may not include a point at which the slope of the sidewall 170SW of the first back wiring contact changes. That is, the first back wiring contact 170 may not be divided into the first portion 170BP of the first back wiring contact and the second portion 170UP of the first back wiring contact.

The contact insulating liner 171 is shown as extending along the sidewall 170SW of the second portion 170UP of the first back wiring contact and the sidewall 170SW of the first portion 170BP of the first back wiring contact. However, implementations of the present disclosure are not limited thereto.

Unlike what is shown, in one example, the contact insulating liner 171 may be formed on the sidewall 170SW of the second portion 170UP of the first back wiring contact but may not be formed on the sidewall 170SW of the first portion 170BP of the first back wiring contact. In another example, the contact insulating liner 171 may not be formed on the sidewall 170SW of the second portion 170UP of the first back wiring contact but may be formed on the sidewall 170SW of the first portion 170BP of the first back wiring contact. In still another example, a portion of the contact insulating liner 171 on the sidewall 170SW of the second portion 170UP of the first back wiring contact may not be directly connected to a portion of the contact insulating liner 171 on the sidewall 170SW of the first portion 170BP of the first back wiring contact.

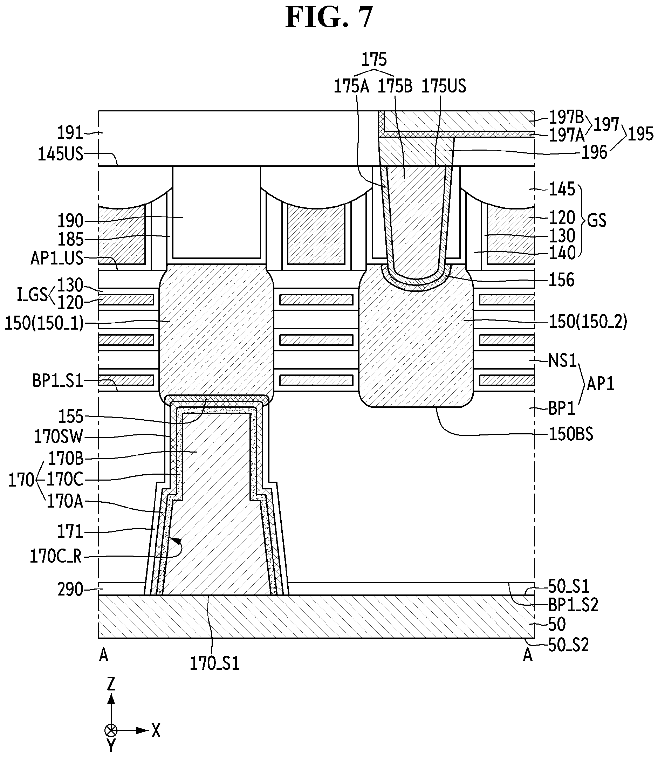

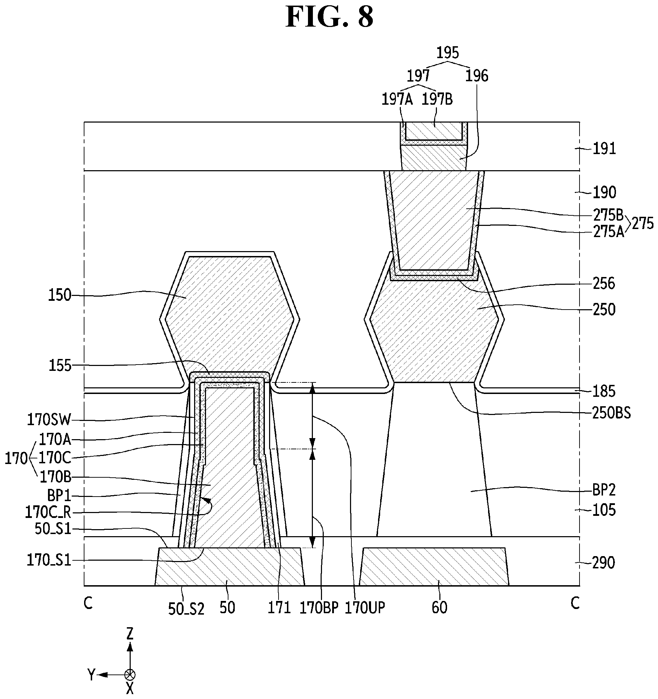

FIG. 7 and FIG. 8 are diagrams for illustrating a semiconductor device according to some implementations. For convenience of description, the following description focuses on differences thereof from the description set forth above using FIG. 5 and FIG. 6.

Referring to FIG. 7 and FIG. 8, in a semiconductor device according to some implementations, the sacrificial epitaxial pattern (170SC in FIG. 5) may not be disposed under the first source/drain pattern 150 connected to the first front source/drain contact 175.

The sacrificial epitaxial pattern (170SC in FIG. 5) may not be disposed under the second source/drain pattern 250 connected to the second front source/drain contact 275.

The sacrificial epitaxial pattern (170SC in FIG. 5) may be disposed under the first and second source/drain patterns 150 and 250 respectively connected to the first back wiring contact 170 and the second back wiring contact 270 in FIG. 1. The sacrificial epitaxial pattern 170SC formed during the manufacturing process may be removed in a process of forming the first and second back source/drain contacts 170 and 270.

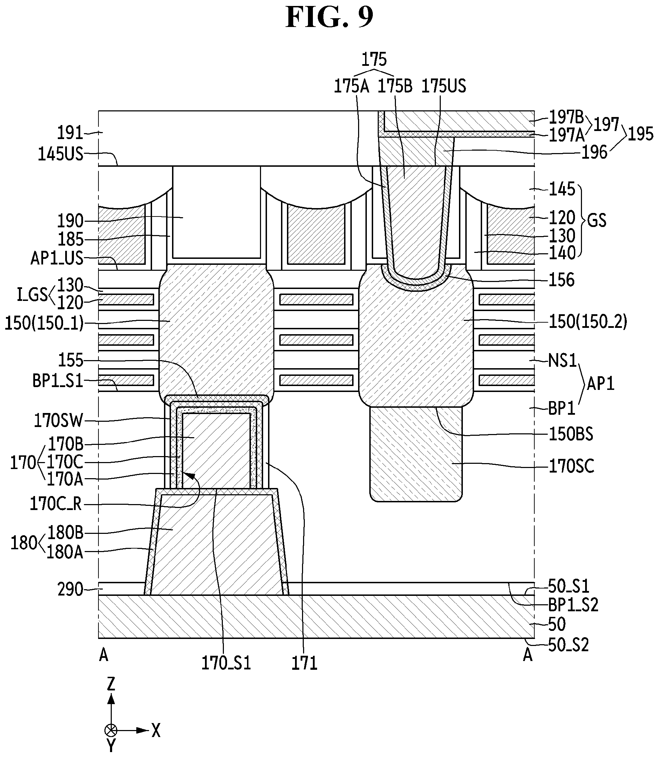

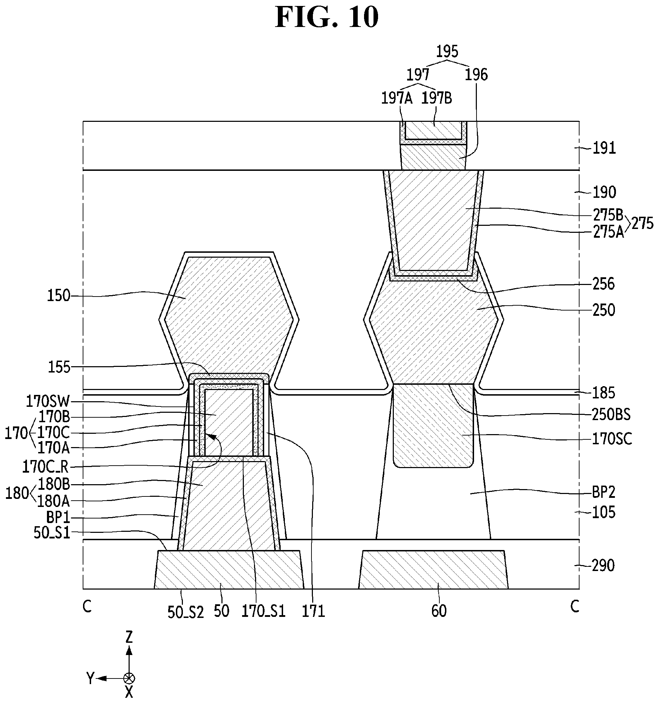

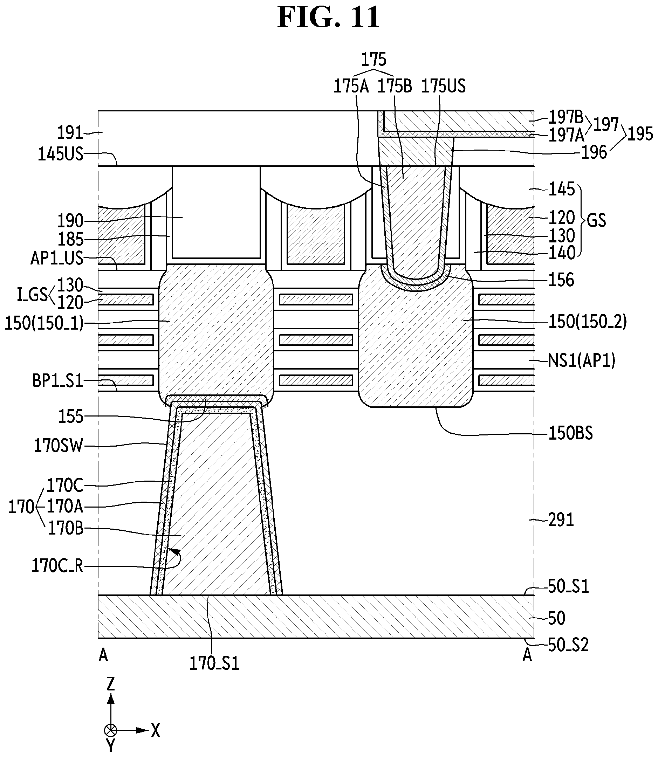

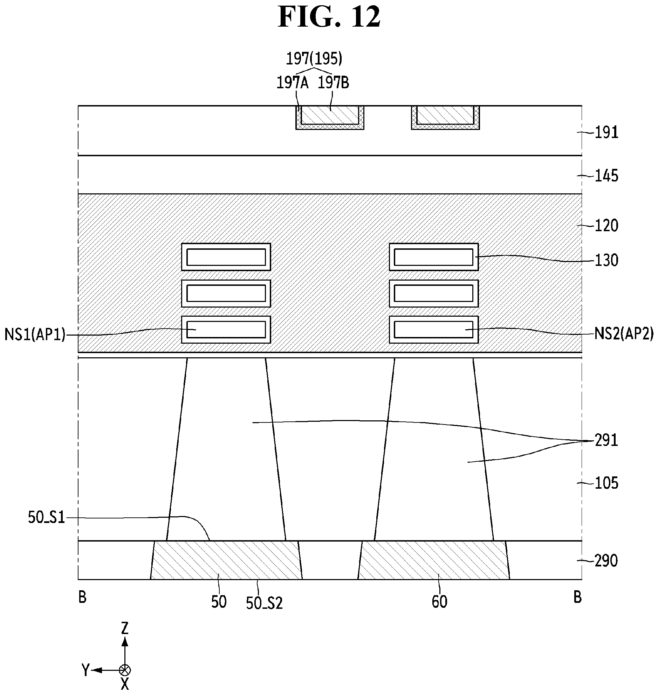

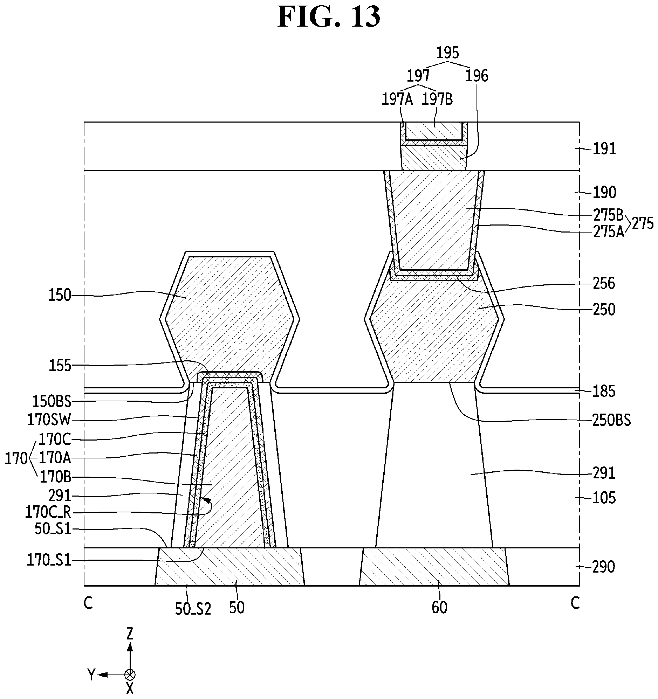

FIG. 9 and FIG. 10 are diagrams for illustrating a semiconductor device according to some implementations. FIGS. 11 to 13 are diagrams for illustrating semiconductor devices according to some implementations.

Referring to FIG. 9 and FIG. 10, the semiconductor device according to some implementations may further include a back contact connection pattern 180 disposed between the first back wiring contact 170 and the first back wiring line 50.

The back contact connection pattern 180 may connect the first back wiring contact 170 and the first back wiring line 50 to each other.

The back contact connection pattern 180 includes a back connection barrier film 180A and a back connection plug film 180B. The back connection barrier film 180A may include at least one of metal, conductive metal nitride, conductive metal carbide, conductive metal oxide, conductive metal oxynitride, conductive metal silicon nitride, conductive metal carbonitride, and two-dimensional material. The back connection plug film 180B may include a metal.

Unlike what is shown, in one example, the back contact connection pattern 180 may have a single conductive film structure. In another example, the back contact connection pattern 180 may further include a ferroelectric material film disposed between the back connection barrier film 180A and the back connection plug film 180B.

Aback connection pattern insulating liner may extend along a sidewall of the back contact connection pattern 180. A sidewall of the back contact connection pattern 180 may extend in the third direction Z.

FIGS. 11 to 13 are diagrams for illustrating a semiconductor device according to some implementations. For convenience of description, the following description focuses on differences thereof from the description set forth above using FIG. 1 to FIG. 4.

Referring to FIGS. 11 to 13, in a semiconductor device according to some implementations, the first active pattern AP1 may include only the first sheet pattern NS 1.

The second active pattern AP2 may include only the second sheet pattern NS2. In other words, the first active pattern AP1 may not include the first lower pattern (BP1 in FIG. 3). The second active pattern AP2 may not include the second lower pattern (BP2 in FIG. 3).

Aback inserted insulating film 291 may be disposed between the first source/drain pattern 150 and the first back wiring line 50. The back inserted insulating film 291 may be disposed between the second source/drain pattern 250 and the second back wiring line 60.

The first back wiring contact 170 may be disposed within the back inserted insulating film 291. The back inserted insulating film 291 may cover the first back wiring contact 170. The back inserted insulating film 291 may cover the sidewall 170SW of the first back wiring contact.

Since the first back wiring contact 170 is disposed within the back inserted insulating film 291, the contact insulating liner 171 may not be disposed on the sidewall 170SW of the first back wiring contact. The back inserted insulating film 291 may contact the sidewall 170SW of the first back wiring contact.

The back inserted insulating film 291 may be formed by filling a space obtained by removing the first lower pattern BP1 and the second lower pattern BP2 with an insulating material. The back inserted insulating film 291 may include an insulating material.

When the back inserted insulating film 291 includes the same material as that of the field insulating film 105, a boundary between the back inserted insulating film 291 and the field insulating film 105 may not be defined. In this case, an insulating pattern surrounding the first back wiring contact 170 may be disposed between the first source/drain pattern 150 and the first back wiring line 50.

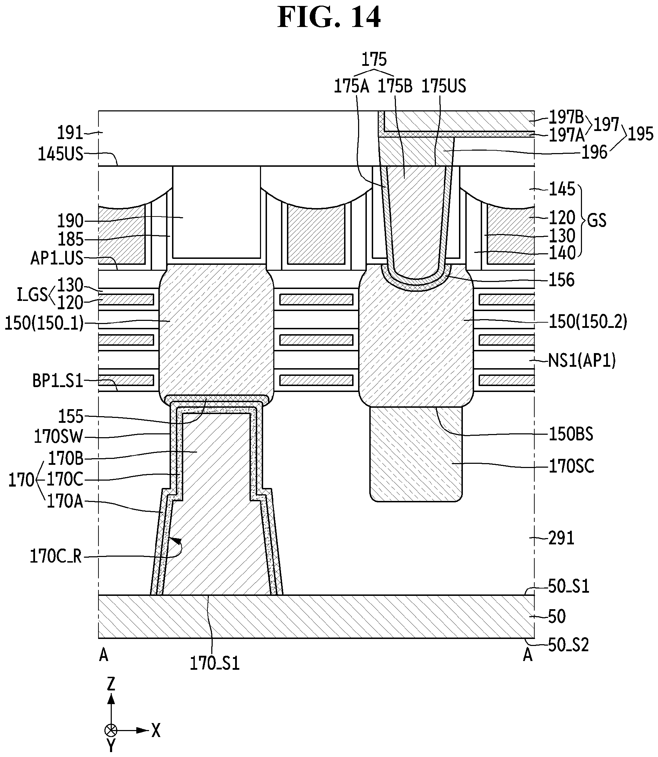

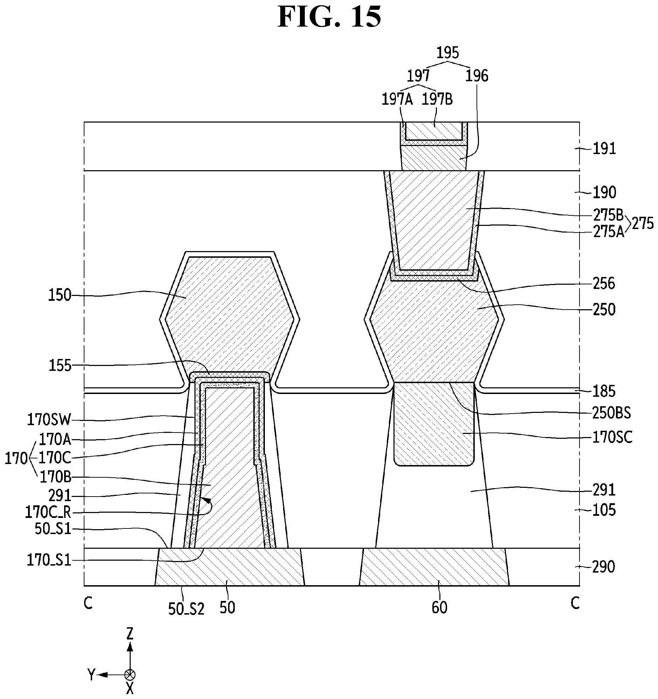

FIG. 14 and FIG. 15 are diagrams for illustrating a semiconductor device according to some implementations. For convenience of description, the following description focuses on differences thereof from the description set forth above using FIG. 11 to FIG. 13.

Referring to FIG. 14 and FIG. 15, the semiconductor device according to some implementations may further include the sacrificial epitaxial pattern 170SC disposed within the back inserted insulating film 291.

The back inserted insulating film 291 may cover the sacrificial epitaxial pattern 170SC. For example, the back inserted insulating film 291 may contact the sacrificial epitaxial pattern 170SC.

The sacrificial epitaxial pattern 170SC in the back inserted insulating film 291 may be disposed between the first source/drain pattern 150 and the first back wiring line 50. The sacrificial epitaxial pattern 170SC in the back inserted insulating film 291 may be disposed between the second source/drain pattern 250 and the second back wiring line 60. The sacrificial epitaxial pattern 170SC may include a semiconductor material.

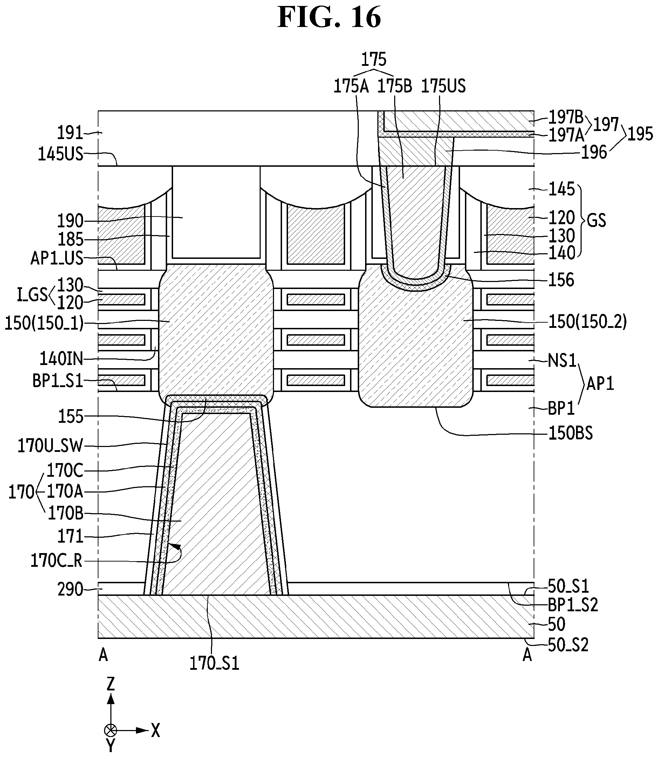

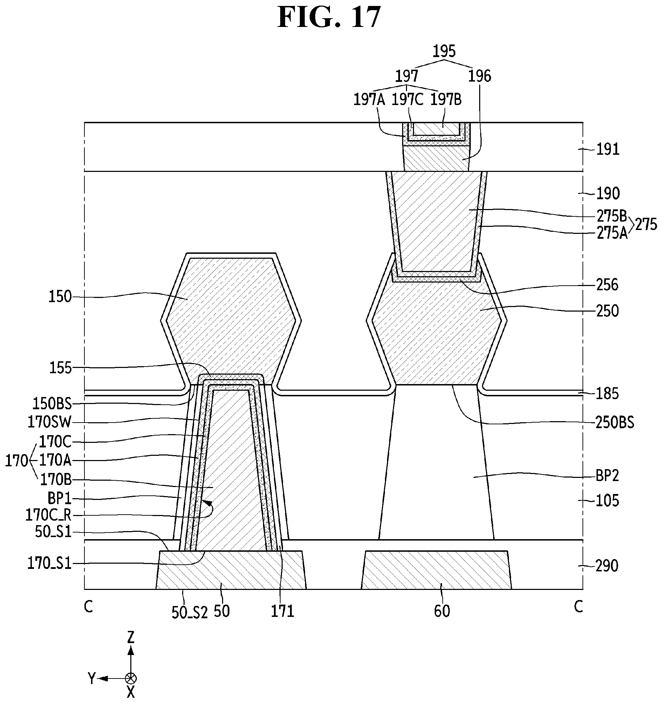

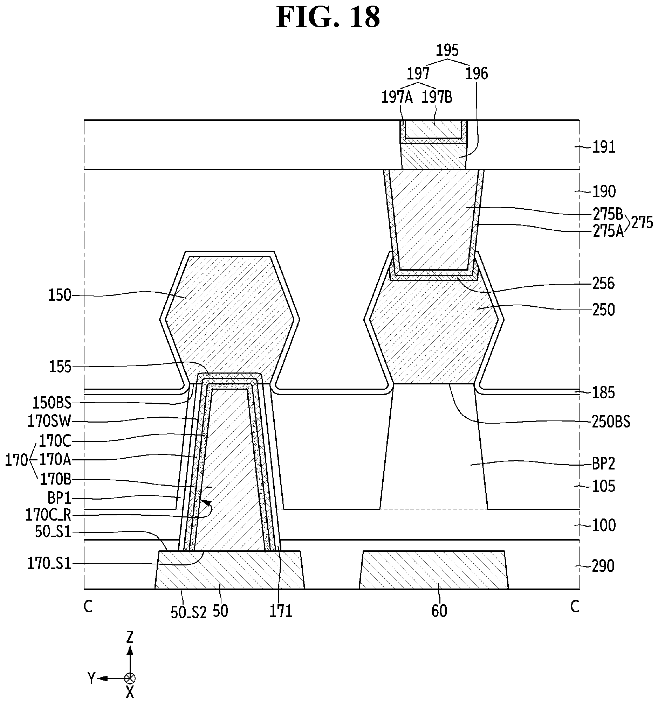

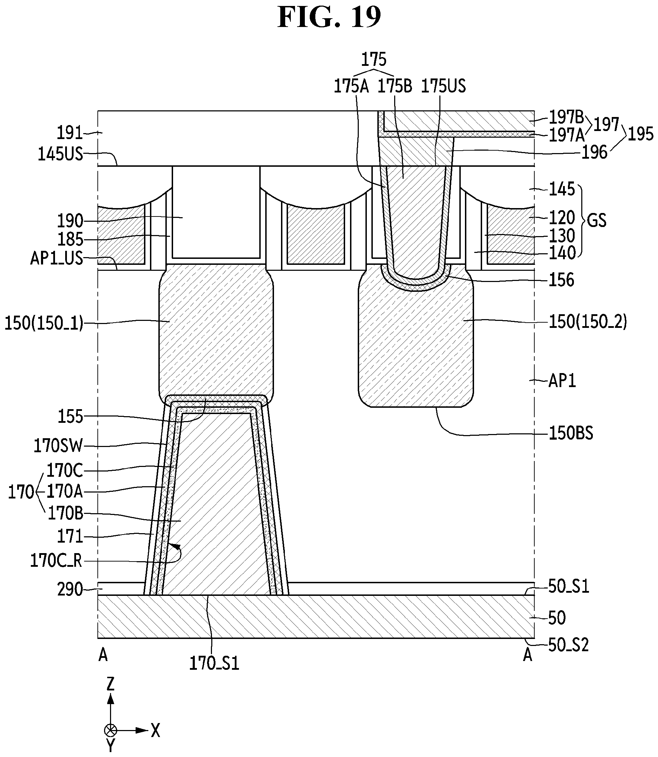

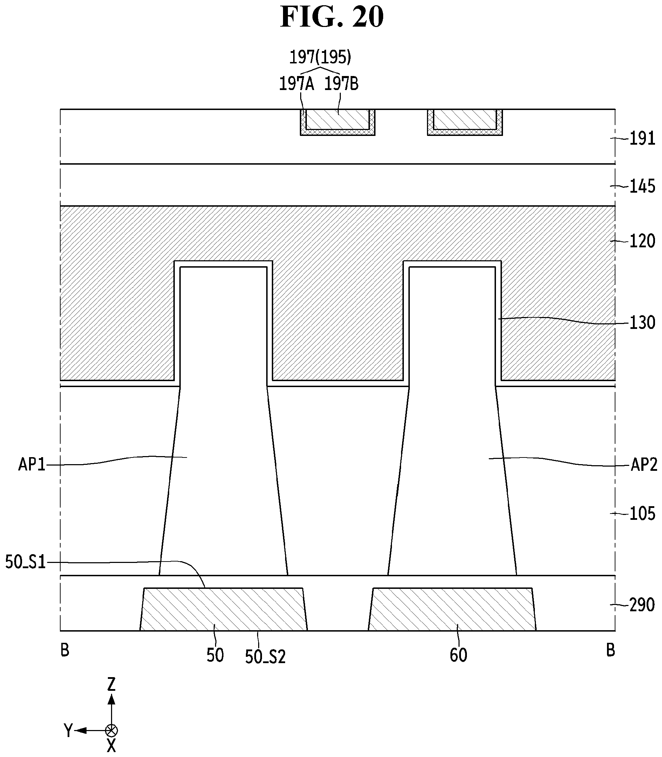

FIG. 16 is a diagram for illustrating a semiconductor device according to some implementations. FIG. 17 is a diagram for illustrating a semiconductor device according to some implementations. FIG. 18 is a diagram for illustrating a semiconductor device according to some implementations. FIG. 19 and FIG. 20 are diagrams for illustrating a semiconductor device according to some implementations. For convenience of description, the following description focuses on differences thereof from the description set forth above using FIG. 1 to FIG. 4.

Referring to FIG. 16, the semiconductor device according to some implementations may further include inner spacers 140IN, each disposed between a respective inner gate structure I_GS and the first source/drain pattern 150.

The inner spacers 140IN may be respectively disposed between the first sheet patterns NS1 adj acent to each other in the third direction Z, and between the lowest first sheet pattern NS1 and the first lower pattern BP1. The inner spacer 140IN may contact the first source/drain pattern 150.

Each inner spacer 140IN may include an insulating material.

In one example, in a cross-sectional view of the second active pattern AP2 cut in the first direction X, each inner spacer 140IN may be disposed between a respective inner gate structure I_GS and the second source/drain pattern 250.

In another example, in a cross-sectional view of the second active pattern AP2cut in the first direction X, each inner spacer 140IN may not be disposed between a respective inner gate structure I_GS and the second source/drain pattern 250. In other words, a cross-sectional view of the second active pattern AP2 cut in the first direction X may be similar to FIG. 2.

Referring to FIG. 17, in the semiconductor device according to some implementations, the front wiring line 197 may further include a front wiring ferroelectric material film 197C disposed between the front wiring barrier film 197A and the front wiring plug film 197B.

The front wiring ferroelectric material film 197C may include a ferroelectric material. Description about the front wiring ferroelectric material film 197C may be substantially the same as the description about the gate ferroelectric material film as set forth above.

The front wiring line 197 includes the front wiring ferroelectric material film 197C such that the resistance of the front wiring line 197 may be reduced.

Unlike what is shown, the second front source/drain contact 275 may further include a ferroelectric material film disposed between the second front contact barrier film 275A and the second front contact plug film 275B.

Referring to FIG. 18, in the semiconductor device according to some implementations, the first lower pattern BP1 and the second lower pattern BP2 may protrude from the substrate 100 in the third direction Z.

The substrate 100 may be disposed between the back interlayer insulating film 290 and the first lower pattern BP1 and between the back interlayer insulating film 290 and the second lower pattern BP2. The back interlayer insulating film 290 may be in contact with the substrate 100.

For example, the first back wiring contact 170 may extend through the substrate 100. When the back contact connection pattern 180 is disposed as shown in FIG. 9 and FIG. 10, the back contact connection pattern 180 may extend through the substrate 100.

The substrate 100 may be made of bulk silicon or silicon-on-insulator (SOI). Alternatively, the substrate 100 may be a silicon substrate, or may include a material other than silicon, such as silicon germanium, silicon germanium on insulator (SGOI), indium antimonide, lead telluride compound, indium arsenide, indium phosphide, gallium arsenide or gallium antimonide. However, implementations of the present disclosure are not limited thereto.

Referring to FIG. 19 and FIG. 20, in a semiconductor device according to some implementations, the first active pattern AP1 may not include the first sheet pattern (NS1 in FIG. 2).

The second active pattern AP2 may not include the second sheet pattern (NS2 in FIG. 3).

The inner gate structure (I_GS in FIG. 2) may not be disposed between the first source/drain patterns 150 adjacent to each other in the first direction X.

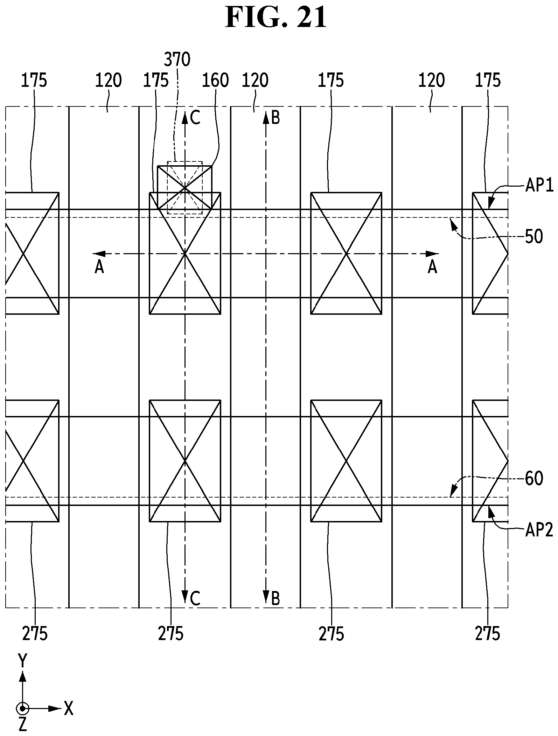

FIGS. 21 to 25 are diagrams for illustrating a semiconductor device according to some implementations. For convenience of description, the following description focuses on differences thereof from the description set forth above using FIG. 1 to FIG. 4.

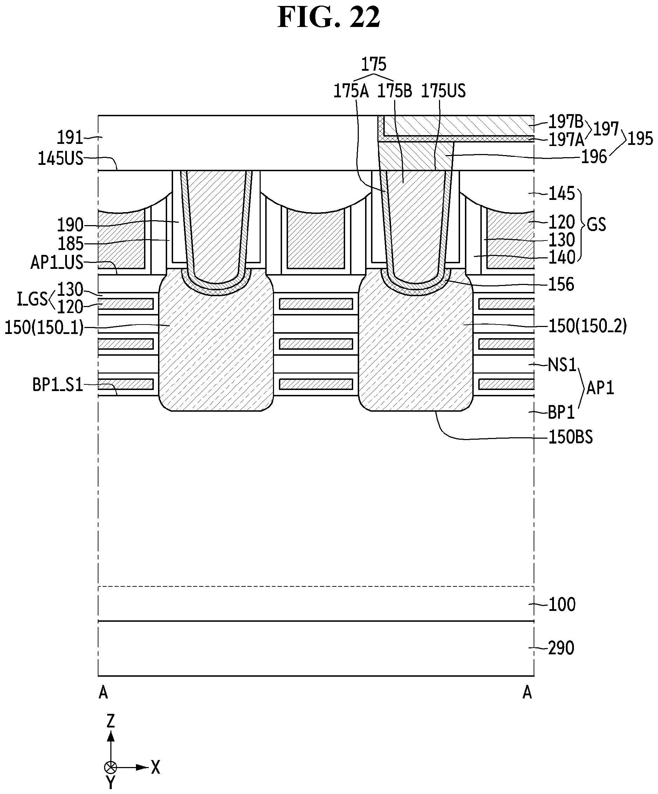

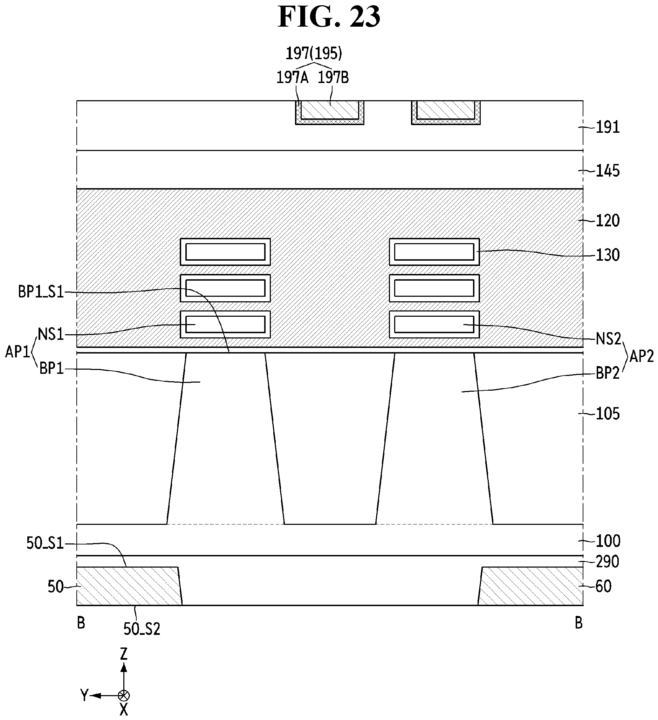

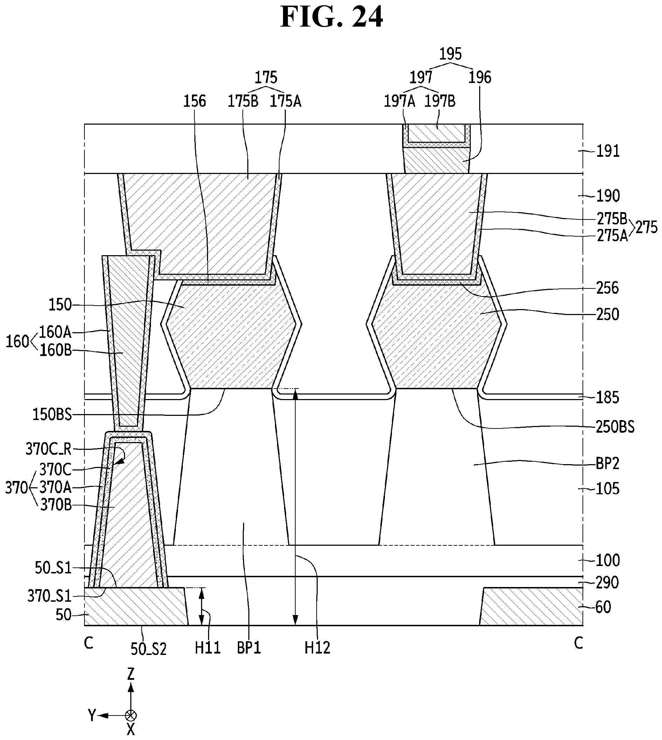

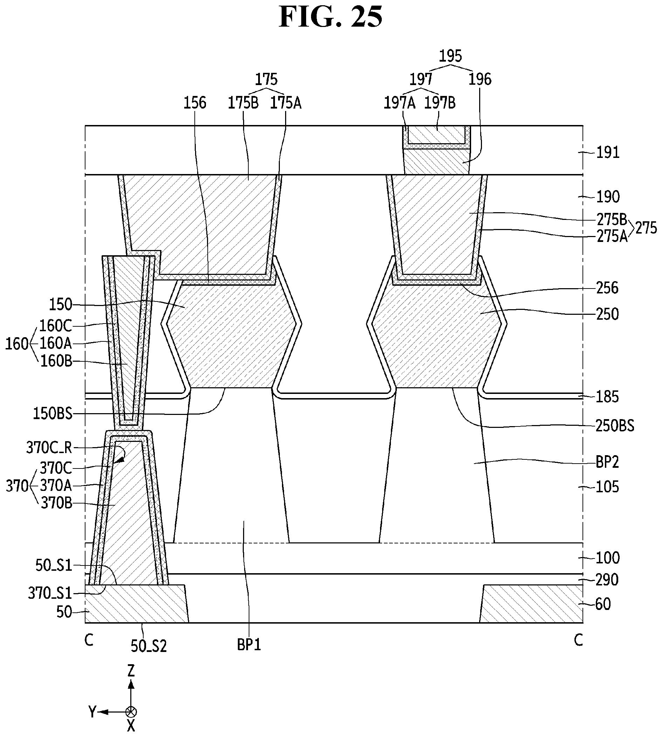

For reference, FIG. 21 is an example layout diagram for illustrating a semiconductor device according to some implementations. FIG. 22 is a cross-sectional view cut along A - A in FIG. 21. FIG. 23 is a cross-sectional view cut along B - B in FIG. 21. FIG. 24 and FIG. 25 are cross-sectional views cut along line C - C of FIG. 21, respectively.

Referring to FIGS. 21 to 25, the semiconductor device according to some implementations may further include a front contact connection via 160.

The first lower pattern BP1 and the second lower pattern BP2 may protrude from the substrate 100 in the third direction Z. For example, the first lower pattern BP1 and the second lower pattern BP2 may protrude from the upper surface of the substrate 100.

Unlike what is shown, the substrate 100 may not be disposed. In this case, the first lower pattern BP1 and the second lower pattern BP2 may contact the back interlayer insulating film 290.

When another active pattern adjacent to the first active pattern AP1 in the second direction Y is disposed, the third back wiring contact 370 may be disposed between the first active pattern AP1 and another active pattern adjacent to each other in the second direction Y Unlike what is shown, a third back wiring contact 370 may be disposed between the first active pattern AP1 and the second active pattern AP2.

A semiconductor device according to some implementations may include the third back wiring contact 370 connected to the first back wiring line 50.

The third back wiring contact 370 may be disposed between lower patterns to each other in the second direction Y The third back wiring contact 370 may overlap a portion of the field insulating film 105 disposed between the lower patterns in the third direction Z.

The third back wiring contact 370 is shown as having a contact shape. However, implementations of the present disclosure are not limited thereto. The third back wiring contact 370 may have a line shape.

The third back wiring contact 370 may connect the first source/drain pattern 150 and the first back wiring line 50 to each other. The third back wiring contact 370 may be connected to the first surface 50_S1 of the first back wiring line.

The third back wiring contact 370 may be connected to the first front source/drain contact 175 via the front contact connection via 160. The third back wiring contact 370 may be electrically connected to the first source/drain pattern 150 via the first front source/drain contact 175.

The third back wiring contact 370 may extend through the substrate 100. The third back wiring contact 370 may extend in the third direction Z. For example, a portion of the third back wiring contact 370 may protrude in the third direction Z beyond the upper surface of the substrate 100. A portion of the third back wiring contact 370 may be disposed within the field insulating film 105.

The third back wiring contact 370 may not overlap with the first lower pattern BP1 in the third direction Z. The third back wiring contact 370 may not overlap the bottom surface 150BS of the first source/drain pattern in the third direction Z. The third back wiring contact 370 may not be disposed within the first lower pattern BP1. The third back wiring contact 370 may overlap the first lower pattern BP1 in the second direction Y

Unlike what is shown, the third back wiring contact 370 may not protrude in the third direction Z beyond the upper surface of the substrate 100.

The third back wiring contact 370 includes a first surface 370_S1 facing the first back wiring line 50. The first surface 370_S1 of the third back wiring contact may be connected to the first back wiring line 50.

The third back wiring contact 370 includes a third back contact barrier film 370A, a third back contact plug film 370B, and a third back ferroelectric material film 370C. The third back ferroelectric material film 370C may be disposed between the third back contact barrier film 370A and the third back contact plug film 370B. The third back contact plug film 370B may fill a third contact plug recess 370C_R defined by the third back ferroelectric material film 370C.

In FIG. 24, a vertical length H11 from the second surface 50_S2 of the first back wiring line to the first surface 370_S1 of the third back wiring contact may be smaller than a vertical length H12 from the second surface 50_S2 of the first back wiring line to the bottom surface 150BS of the first source/drain pattern.

Descriptions about materials respectively included in the third back contact barrier film 370A, the third back contact plug film 370B, and the third back ferroelectric material film 370C may be substantially the same as the descriptions about the materials respectively included in the first back contact barrier film 170A, the first back contact plug film 170B and the first back ferroelectric material film 170C, respectively.

A contact insulating liner may be disposed along a sidewall of the third back wiring contact 370.

The front contact connection via 160 may be disposed between the first front source/drain contact 175 and the third back wiring contact 370. The front contact connection via 160 may connect the first back connection epitaxial pattern 150_1 and the third back wiring contact 370 to each other.

For example, the front contact connection via 160 may be directly connected to the first front source/drain contact 175. The front contact connection via 160 may extend through the source/drain etch stop film 185 so as to be connected to the third back wiring contact 370. A portion of the front contact connection via 160 may be disposed within the field insulating film 105.

The front contact connection via 160 may be spaced apart from the first source/drain pattern 150 in the second direction Y The front contact connection via 160 may overlap the first source/drain pattern 150 in the second direction Y A width in the second direction Y of the front contact connection via 160 may increase as the front contact connection via 160 extends away from the first back wiring line 50.

The front contact connection via 160 includes a front connection via barrier film 160A and a front connection via plug film 160B. The front connection via plug film 160B may be disposed on the front connection via barrier film 160A. The front connection via barrier film 160A may extend along a sidewall and a bottom surface of the front connection via plug film 160B.

For example, the front connection via barrier film 160A may include at least one of, for example, metal, conductive metal nitride, conductive metal carbide, conductive metal oxide, conductive metal oxynitride, conductive metal silicon nitride, conductive metal carbonitride, and two-dimensional material. The front connection via plug film 160B may include a metal.

Unlike what is shown, the front connection via plug film 160B may contact the third back wiring contact 370. The front connection via plug film 160B may contact the third back contact barrier film 370A. The front connection via barrier film 160A may extend along the sidewall of the front connection via plug film 160B, but may not extend along the bottom surface of the front connection via plug film 160B.

In FIG. 24, the front contact connection via 160 may not include a ferroelectric material film disposed between the front connection via barrier film 160A and the front connection via plug film 160B.

In FIG. 25, the front contact connection via 160 further includes a front connection ferroelectric material film 160C disposed between the front connection via barrier film 160A and the front connection via plug film 160B. The front connection ferroelectric material film 160C may include a ferroelectric material. Description about the front connection ferroelectric material film 160C may be substantially the same as the description about the gate ferroelectric material film as set forth above.

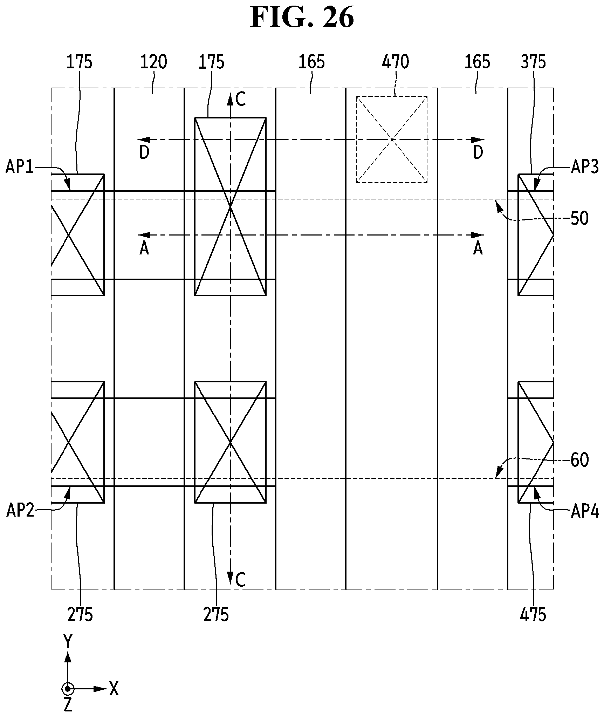

FIGS. 26 to 30 are diagrams for illustrating a semiconductor device according to some implementations. For convenience of description, the following description focuses on differences thereof from the description set forth above using FIG. 1 to FIG. 4.

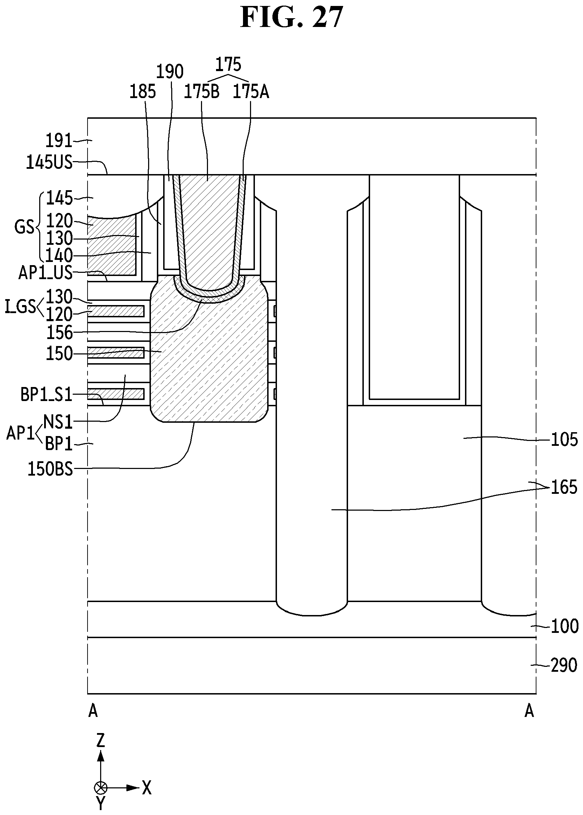

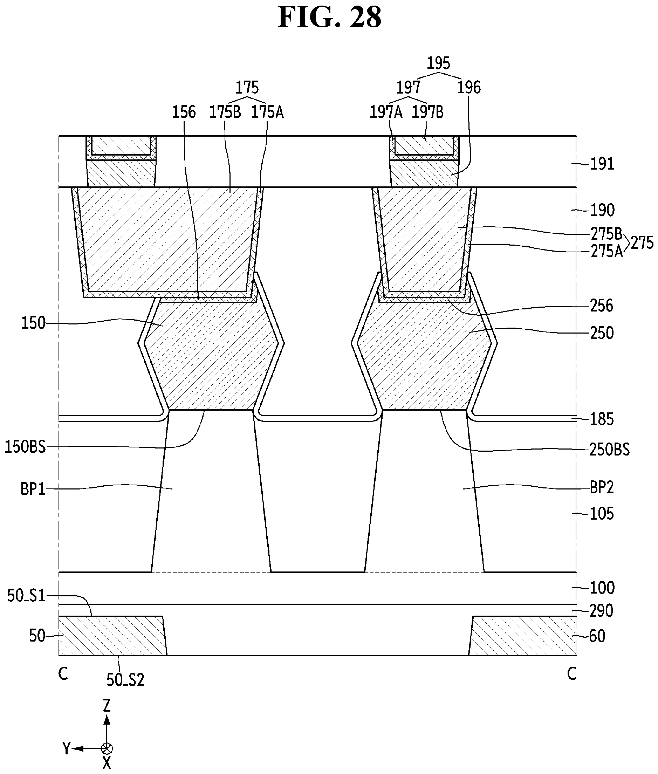

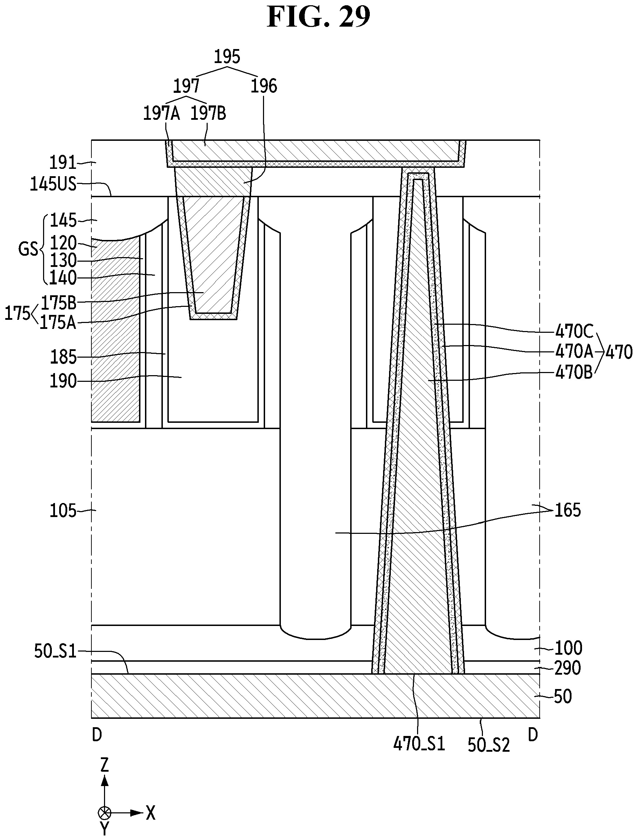

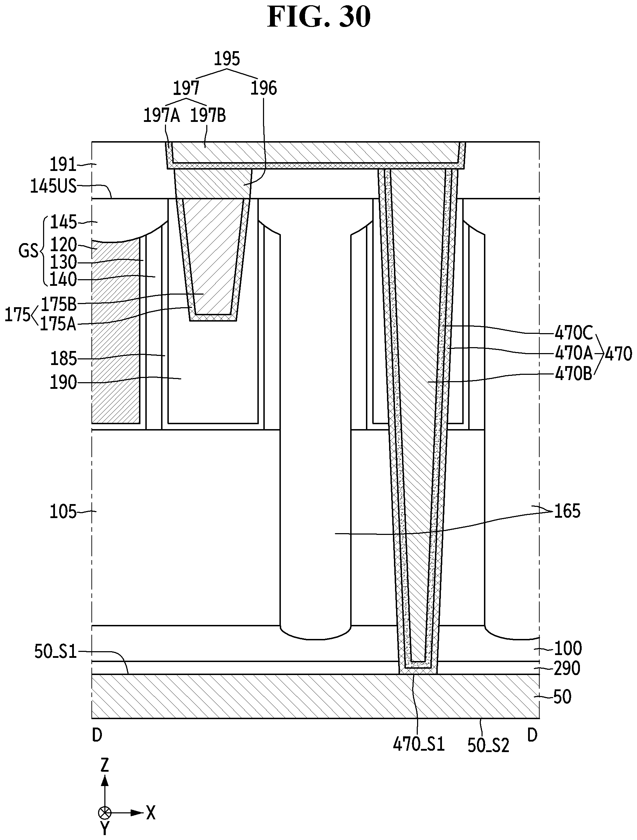

For reference, FIG. 26 is an example layout diagram for illustrating a semiconductor device according to some implementations. FIG. 27 is a cross-sectional view cut along A - A in FIG. 26. FIG. 28 is a cross-sectional view cut along C - C in FIG. 26. FIG. 29 and FIG. 30 are cross-sectional views taken along line D - D of FIG. 26, respectively.

Referring to FIGS. 26 to 30, the semiconductor device according to some implementations may further include a third active pattern AP3, a fourth active pattern AP4, a fourth back wiring contact 470, a third front source/drain contact 375, a fourth front source/drain contact 475, and an element isolation structure 165.

The third active pattern AP3 and the fourth active pattern AP4 may be disposed on the back interlayer insulating film 290. The third active pattern AP3 and the fourth active pattern AP4 may extend in the first direction X. The third active pattern AP3 may be spaced apart from the fourth active pattern AP4 in the second direction Y

The third active pattern AP3 and the fourth active pattern AP4 may be disposed on the first back wiring line 50 and the second back wiring line 60. The third active pattern AP3 and the fourth active pattern AP4 may be disposed on the first surface 50_S1 of the first back wiring line.

The third active pattern AP3 may be spaced apart from the first active pattern AP1 in the first direction X. The first active pattern AP1 and the third active pattern AP3 may be aligned with each other in a line along the first direction X.

The fourth active pattern AP4 may be spaced apart from the second active pattern AP2 in the first direction X. The second active pattern AP2 and the fourth active pattern AP4 may be aligned with each other in a line along the first direction X.

Each of the third active pattern AP3 and the fourth active pattern AP4 may include a lower pattern and a plurality of sheet patterns like each of the first active pattern AP1 and the second active pattern AP2.

The gate electrode may be disposed on the third active pattern AP3 and fourth active pattern AP4.

A source/drain pattern like each of the first source/drain pattern 150 and the second source/drain pattern 250 may be disposed on each of the third active pattern AP3 and fourth active pattern AP4.

Apair of element isolation structures 165 may be disposed on the back interlayer insulating film 290, the first back wiring line 50, and the second back wiring line 60. The element isolation structure 165 may be disposed on the first surface 50_S1 of the first back wiring line and the first surface of the second back wiring line 60.

The pair of element isolation structures 165 may include a first sub-element isolation structure and a second sub-element isolation structure. The first sub-element isolation structure and the second sub-element isolation structure may extend in the second direction Y The first sub-element isolation structure may be spaced apart from the second sub-element isolation structure in the first direction X.

The element isolation structure 165 may isolate the first lower pattern BP1 and the lower pattern included in the third active pattern AP3 from each other. The element isolation structure 165 may isolate the second lower pattern BP2 and the lower pattern included in the fourth active pattern AP4 from each other. The first active pattern AP1 and the third active pattern AP3 are not disposed between the first sub-element isolation structure and the second sub-element isolation structure. The second active pattern AP2 and the fourth active pattern AP4 are not disposed between the first sub-element isolation structure and the second sub-element isolation structure. A portion of the field insulating film 105 may be disposed between the first sub-element isolation structure and the second sub-element isolation structure adj acent to each other in the first direction X.

Unlike what is shown, a dummy active pattern including a semiconductor material may be disposed between the pair of element isolation structures 165.

The first lower pattern BP1 may protrude from the first sub-element isolation structure in the first direction X. The lower pattern included in the third active pattern AP3 may protrude from the second sub-element isolation structure in the first direction X.

A vertical length between the first surface BP1_S1 of the first lower pattern and an upper surface of the element isolation structure 165 may be equal to a vertical length between the first surface BP1_S1 of the first lower pattern and the upper surface 145US of the gate capping pattern. Unlike what is shown, based on the first surface BP1_S1 of the first lower pattern, a vertical level of the upper surface of the element isolation structure 165 may be higher than a vertical level of the upper surface 145US of the gate capping pattern.

The element isolation structure 165 may include an insulating material. The element isolation structure 165 may include at least one, for example, silicon nitride (SiN), silicon oxynitride (SiON), silicon oxide (SiO₂), silicon oxycarbonitride (SiOCN), silicon boronitride (SiBN), and silicon oxyboronitride (SiOBN), silicon oxycarbide (SiOC), and combinations thereof. Each of the first sub-element isolation structure and the second sub-element isolation structure is shown as being formed as a single film. However, implementations of the present disclosure are not limited thereto.

Between the first sub-element isolation structure and the first source/drain pattern 150, an insulating residual pattern may be disposed. The insulating residual pattern may include the same material as that of the gate insulating film 130.

Between the pair of element isolation structures 165, the first front interlayer insulating film 190 and the source/drain etch stop film 185 may be disposed. For example, between the first sub-element isolation structure and the source/drain etch stop film 185, an insulating spacer pattern in contact with the source/drain etch stop film 185 may be disposed. The insulating spacer pattern may include the same material as that of the gate spacer 140.

The first source/drain pattern 150 and the second source/drain pattern 250 may be disposed between the gate electrode 120 and the element isolation structure 165.

The first front source/drain contact 175 and the second front source/drain contact 275 may be disposed between the gate electrode 120 and the element isolation structure 165.

A third front source/drain contact 375 and a fourth front source/drain contact 475 may be respectively disposed on the source/drain patterns respectively disposed on the third active pattern AP3 and fourth active pattern AP4. A shape of each of the third front source/drain contact 375 and the fourth front source/drain contact 475 as cut in the second direction Y may be similar to that in FIG. 28.

The semiconductor device according to some implementations includes a fourth back wiring contact 470 connected to the first back wiring line 50.

The fourth back wiring contact 470 may be disposed between the pair of element isolation structures 165. The fourth back wiring contact 470 may be disposed between the first sub-element isolation structure and the second sub-element isolation structure adjacent to each other in the first direction X.

The fourth back wiring contact 470 may connect the first source/drain pattern 150 and the first back wiring line 50 to each other. The fourth back wiring contact 470 may be connected to the first surface 50_S1 of the first back wiring line.

The fourth back wiring contact 470 may be connected to the first front source/drain contact 175 via the front wiring structure 195. The front wiring line 197 may connect the fourth back wiring contact 470 and the first front source/drain contact 175 to each other. The fourth back wiring contact 470 may be electrically connected to the first source/drain pattern 150 via the first front source/drain contact 175.

The fourth back wiring contact 470 may extend through the substrate 100. The fourth back wiring contact 470 may extend in the third direction Z. For example, the fourth back wiring contact 470 may extend from the first back wiring line 50 to the front wiring line 197.

The fourth back wiring contact 470 may not overlap with the first lower pattern BP1 in the third direction Z. The fourth back wiring contact 470 may not overlap the bottom surface 150BS of the first source/drain pattern in the third direction Z. The fourth back wiring contact 470 may not be disposed within the first lower pattern BP1. The fourth back wiring contact 470 may not overlap with the first lower pattern BP1 in the second direction Y

The fourth back wiring contact 470 includes a first surface 470_S1 facing the first back wiring line 50. The first surface 470_S1 of the fourth back wiring contact may be connected to the first back wiring line 50. A vertical length from the second surface 50_S2 of the first back wiring line to the first surface 470_S1 of the fourth back wiring contact may be smaller from a vertical length H12 from the second surface 50_S2 of the first back wiring line to the bottom surface150BS of the first source/drain pattern.

The fourth back wiring contact 470 includes a fourth back contact barrier film 470A, a fourth back contact plug film 470B, and a fourth back ferroelectric material film 470C. The fourth back ferroelectric material film 470C may be disposed between the fourth back contact barrier film 470A and the fourth back contact plug film 470B.

Descriptions of materials respectively included in the fourth back contact barrier film 470A, the fourth back contact plug film 470B, and the fourth back ferroelectric material film 470C may be substantially the same as the descriptions about the materials respectively included in the first back contact barrier film 170A, the first back contact plug film 170B and the first back ferroelectric material film 170C, respectively.

In FIG. 29, a width in the first direction X of the fourth back wiring contact 470 may decrease as the fourth back wiring contact 470 extends away from the first back wiring line 50.

In FIG. 30, a width in the first direction X of the fourth back wiring contact 470 may increase as the fourth back wiring contact 470 extends away from the first back wiring line 50.

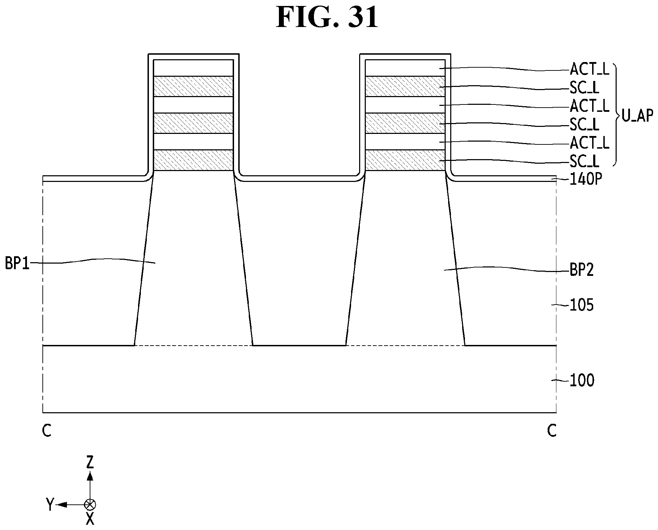

FIGS. 31 to 38 are diagrams of intermediate structures corresponding to intermediate steps of a semiconductor device manufacturing method according to some implementations.

Referring to FIG. 31, the first lower pattern BP1 and an upper pattern structure U_AP may be formed on the substrate 100.

The second lower pattern BP1 and an upper pattern structure U_AP may be formed on the substrate 100.

Each of the first lower pattern BP1 and the second lower pattern BP2 may extend in the first direction X. The upper pattern structure U_AP may be disposed on each of the first lower pattern BP1 and the second lower pattern BP2.

The upper pattern structure U AP may include sacrificial patterns SC_L and active patterns ACT_L alternately stacked on top of each other. The sacrificial patterns SC_L and the active patterns ACT_L may be alternately stacked on top of each other while being disposed on each of the first lower pattern BP1 and the second lower pattern BP2.

For example, the sacrificial pattern SC_L may include a silicon-germanium layer. The active pattern ACT_L may include a silicon film.

The field insulating film 105 may be formed on the substrate 100. The field insulating film 105 may cover at least a portion of the sidewall of the first lower pattern BP1 and at least a portion of the sidewall of the second lower pattern BP2.

Subsequently, a pre-spacer film 140P may be formed along a sidewall and an upper surface of the upper pattern structure U_AP and the upper surface of the field insulating film 105. The pre-spacer film 140P may include at least one of, for example, silicon nitride (SiN), silicon oxynitride (SiON), silicon oxycarbonitride (SiOCN), silicon boron nitride (SiBN), silicon oxyboron nitride (SiOBN), silicon oxycarbide (SiOC) and combinations thereof.

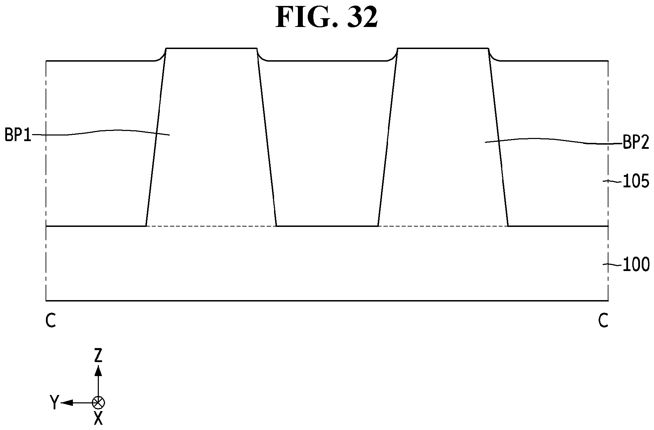

Referring to FIG. 31 and FIG. 32, the upper pattern structure U_AP of the first lower pattern BP1 and the upper pattern structure U_AP of the second lower pattern BP2 may be removed using an etching process.

While the upper pattern structure U_AP is being removed, a portion of the pre-spacer film 140P disposed on the upper surface of the upper pattern structure U_AP may be removed. Furthermore, at least a portion of the pre-spacer film 140P disposed on the sidewall of the upper pattern structure U_AP may be removed.

A portion of the first lower pattern BP1 and/or a portion of the second lower pattern BP2 may be removed to form the sacrificial epitaxial pattern (170SC in FIG. 6). Thus, a sacrificial epitaxial hole in which the sacrificial epitaxial pattern 170SC is to be formed may be formed in the first lower pattern BP1 and/or the second lower pattern BP2. Subsequently, the sacrificial epitaxial pattern 170SC may be formed within the sacrificial epitaxial hole.

Hereinafter, some implementations are described in which a manufacturing process is performed in a state where the sacrificial epitaxial pattern 170SC is not formed.

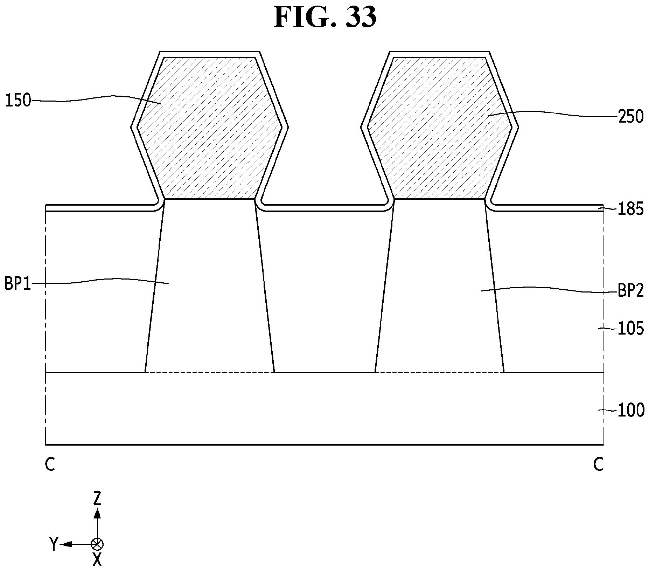

Referring to FIG. 33, the first source/drain pattern 150 may be formed on the first lower pattern BP1.

The second source/drain pattern 250 may be formed on the second lower pattern BP2. When the first source/drain pattern 150 and the second source/drain pattern 250 are respectively included in the source/drains of transistors of different conductivity types, the first source/drain pattern 150 and the second source/drain pattern 250 may be formed in different epitaxial processes.

The source/drain etch stop film 185 may be formed along the upper surface of the field insulating film 105, a profile of the first source/drain pattern 150, and a profile of the second source/drain pattern 250.

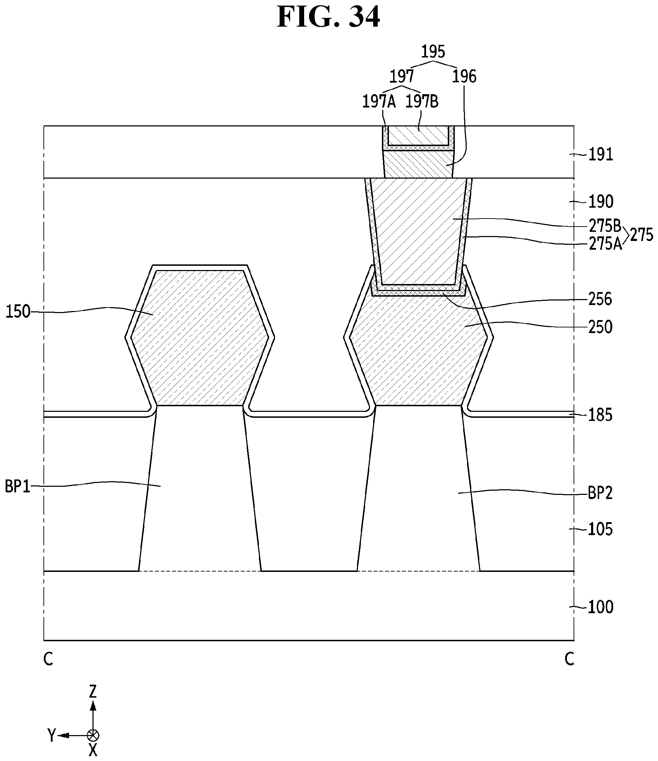

Referring to FIG. 34, the first front interlayer insulating film 190 may be formed on the source/drain etch stop film 185.

Subsequently, the second front source/drain contact 275 may be formed on the second source/drain pattern 250. The second front source/drain contact 275 is connected to the second source/drain pattern 250.

The second front interlayer insulating film 191 may be formed on the first front interlayer insulating film 190 and the second front source/drain contact 275. The front wiring structure 195 may be formed within the second front interlayer insulating film 191.

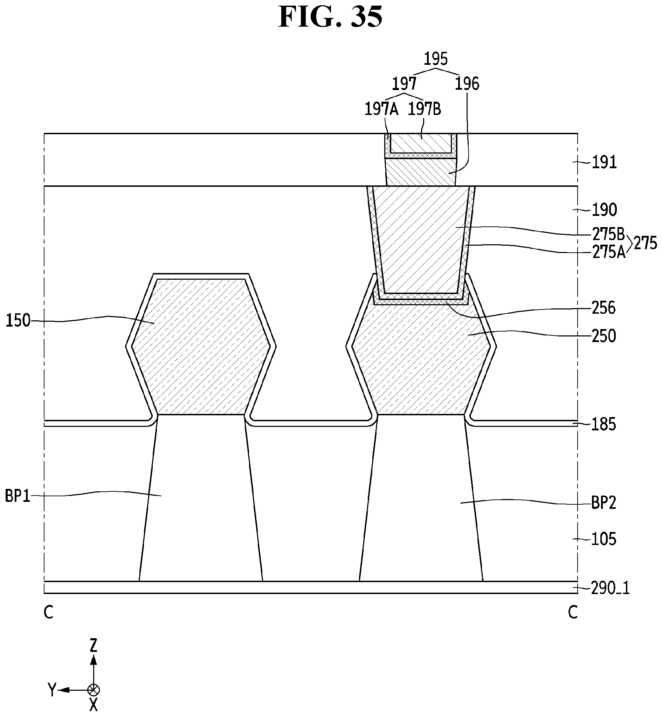

Referring to FIG. 34 and FIG. 35, the substrate 100 may be removed.

The substrate 100 may be removed to expose the first lower pattern BP1 and the second lower pattern BP2. The field insulating film 105 may be exposed.

Subsequently, a first back interlayer insulating film 290_1 may be formed on the first lower pattern BP1 and the second lower pattern BP2.

Contrary to what is shown, the first back interlayer insulating film 290_1 may not be formed.

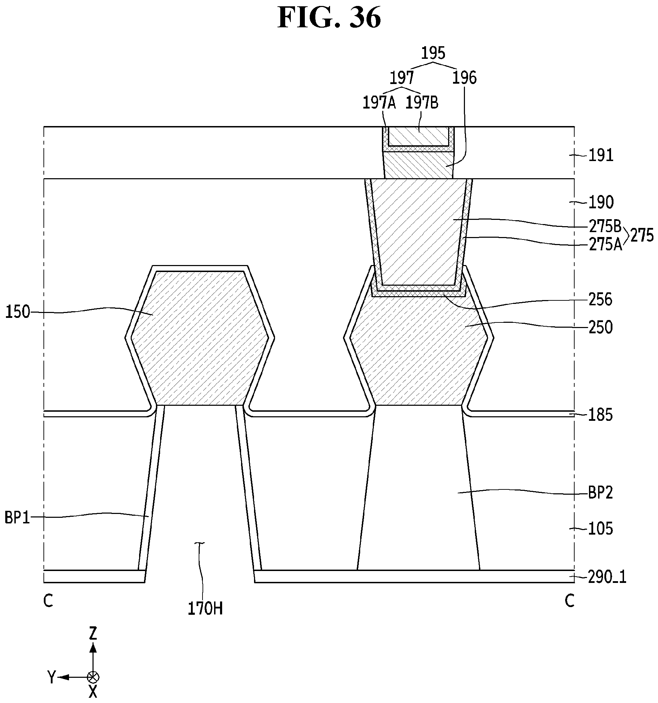

Referring to FIG. 35 and FIG. 36, a first back source/drain contact hole 170H may be formed by removing a portion of the first lower pattern BP1.

The first back source/drain contact hole 170H may expose the first source/drain pattern 150.

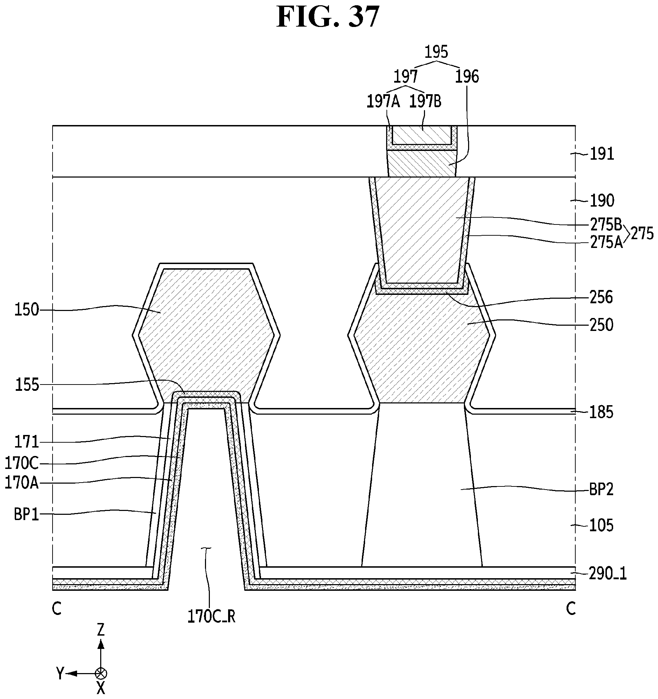

Referring to FIG. 36 and FIG. 37, a contact insulating liner 171 may be formed on a sidewall of the first back source/drain contact hole 170H.

On the exposed first source/drain pattern 150, the first back contact silicide film 155 may be formed.

Subsequently, the first back contact barrier film 170A may be formed along a sidewall of the first back source/drain contact hole 170H and an upper surface of the first back interlayer insulating film 290_1. The first back contact barrier film 170A may be formed on the contact insulating liner 171 and the first back contact silicide film 155.

The first back ferroelectric material film 170C may be formed on the first back contact barrier film 170A. The first back ferroelectric material film 170C may be formed along a profile of the first back contact barrier film 170A. The first back ferroelectric material film 170C may define the first contact plug recess 170C_R.

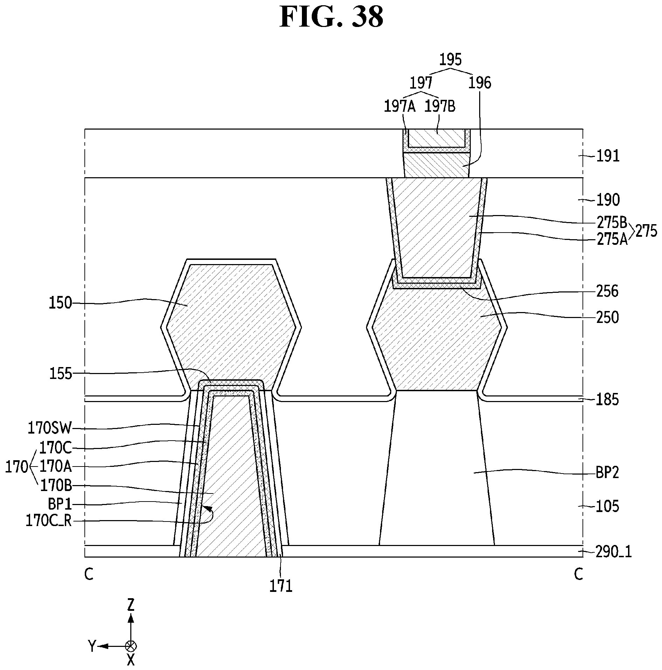

Referring to FIG. 37 and FIG. 38, the first back contact plug film 170B may be formed within the first contact plug recess 170C_R.

The first back contact plug film 170B may fill the first contact plug recess 170C_R. Thus, the first back wiring contact 170 may be formed.

While the first back contact plug film 170B is formed, the first back contact barrier film 170A and the first back ferroelectric material film 170C formed along the upper surface of the first back interlayer insulating film 290_1 may be removed.

Subsequently, referring to FIG. 4, a second back interlayer insulating film may be formed on the first back source/drain contact 170. The first back interlayer insulating film 290_1 and the second back interlayer insulating film may constitute the back interlayer insulating film 290. The first back wiring line 50 and the second back wiring line 60 may be formed within the second back interlayer insulating film.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

Although implementations of the present disclosure have been described with reference to the accompanying drawings, the present disclosure is not limited to the above implementations, but may be implemented in various different forms. A person skilled in the art may appreciate that the present disclosure may be practiced in other concrete forms without changing the technical spirit or essential characteristics of the present disclosure. Therefore, it should be appreciated that the implementations as described above is not restrictive but illustrative in all respects.

## Claims

1. A semiconductor device comprising:
a back interlayer insulating film;
a back wiring line disposed within the back interlayer insulating film, the back wiring line including a first surface and a second surface opposite to each other in a first direction;
a fin-type pattern disposed on the first surface of the back wiring line, the fin-type pattern extending in a second direction;
a source/drain pattern disposed on the fin-type pattern, wherein a bottom surface of the source/drain pattern is connected to the fin-type pattern and faces the back wiring line; and
a back wiring contact connecting the back wiring line and the source/drain pattern to each other,
wherein the back wiring contact includes a back contact barrier film, a back contact plug film, and a back ferroelectric material film, the back ferroelectric material film being disposed between the back contact barrier film and the back contact plug film,
wherein the back wiring contact includes a third surface facing the back wiring line, and
wherein a vertical length from the second surface of the back wiring line to the third surface of the back wiring contact is less than a vertical length from the second surface of the back wiring line to the bottom surface of the source/drain pattern.

2. The semiconductor device of claim 1, wherein the back wiring contact is disposed between the source/drain pattern and the back wiring line, and wherein the back wiring contact overlaps the source/drain pattern in the first direction.

3. The semiconductor device of claim 2, further comprising a contact insulating liner disposed between the back wiring contact and the fin-type pattern, the contact insulating liner extending along a sidewall of the back wiring contact.

4. The semiconductor device of claim 2, further comprising a buried conductive pattern disposed between the back wiring contact and the back wiring line.

5. The semiconductor device of claim 2, wherein the fin-type pattern is in contact with the back interlayer insulating film.

6. The semiconductor device of claim 2, further comprising:
a second source/drain pattern disposed on the fin-type pattern; and
a sacrificial epitaxial pattern disposed within the fin-type pattern and between the second source/drain pattern and the back wiring line.

7. The semiconductor device of claim 1, further comprising a front source/drain contact disposed on the source/drain pattern,
wherein the source/drain pattern is disposed between the front source/drain contact and the back wiring line, and
wherein the back wiring contact is electrically connected to the source/drain pattern via the front source/drain contact.

8. The semiconductor device of claim 7, further comprising a contact connection via disposed between the front source/drain contact and the back wiring contact,
wherein the contact connection via overlaps the source/drain pattern in a third direction.

9. The semiconductor device of claim 8, wherein the contact connection via includes a via barrier film, a via plug film, and a front ferroelectric material film, and wherein the front ferroelectric material film is disposed between the via barrier film and the via plug film.

10. The semiconductor device of claim 7, further comprising a front wiring line disposed on the front source/drain contact and connected to the front source/drain contact,
wherein the front wiring line connects the front source/drain contact and the back wiring contact to each other.

11. The semiconductor device of claim 1, further comprising a front wiring line disposed on the source/drain pattern, wherein the front wiring line includes a wiring plug film and a front ferroelectric material film.

12. A semiconductor device comprising:
a back interlayer insulating film;
a back wiring line disposed within the back interlayer insulating film, the back wiring line including a first surface and a second surface opposite to each other in a first direction;
a first source/drain pattern disposed on the first surface of the back wiring line; and
a back wiring contact disposed between the first source/drain pattern and the back wiring line, the back wiring contact being connected to the first source/drain pattern and overlapping the first source/drain pattern in the first direction,
wherein the back wiring contact includes a back contact barrier film, a back contact plug film, and a ferroelectric material film, the ferroelectric material film being disposed between the back contact barrier film and the back contact plug film.

13. The semiconductor device of claim 12, further comprising a fin-type pattern disposed on the first surface of the back wiring line and extending in a second direction,
wherein the fin-type pattern is disposed between the first source/drain pattern and the back wiring line, and
wherein at least a portion of the back wiring contact is disposed within the fin-type pattern.

14. The semiconductor device of claim 13, further comprising a contact insulating liner disposed between the back wiring contact and the fin-type pattern and extending along a sidewall of the back wiring contact.

15. A semiconductor device comprising:
a back interlayer insulating film;
a back wiring line disposed within the back interlayer insulating film, the back wiring line including a first surface and a second surface opposite to each other in a first direction;
a fin-type pattern disposed on the first surface of the back wiring line, the fin-type pattern extending in a second direction;
a plurality of sheet patterns disposed on the fin-type pattern;
a gate electrode disposed on the fin-type pattern, surrounding the plurality of sheet patterns, and extending in a third direction;
a source/drain pattern disposed on the fin-type pattern and connected to the plurality of sheet patterns, wherein the source/drain pattern is disposed on a side surface of the gate electrode, wherein a bottom surface of the source/drain pattern is connected to the fin-type pattern and faces the back wiring line; and
a back wiring contact connecting the back wiring line and the source/drain pattern to each other,
wherein the back wiring contact includes a back contact barrier film, a back contact plug film, and a back ferroelectric material film, the back ferroelectric material film being disposed between the back contact barrier film and the back contact plug film,
wherein the back wiring contact includes a third surface facing the back wiring line, and
wherein a vertical length from the second surface of the back wiring line to the third surface of the back wiring contact is less than a vertical length from the second surface of the back wiring line to the bottom surface of the source/drain pattern.
